# EUROPEAN PATENT SPECIFICATION

(11) **EP 2 930 210 B1**
(45) Date of publication and mention of the grant of the patent: **25.01.2023**
(21) Application number: 13862355.8
(22) Date of filing: 28.11.2013
(51) Int. Cl.: C08L 53/02, C08F 8/04, C08F 8/06, C08F 8/42, C08F 297/04, H01L 51/50, H05B 33/04

(54) **RESIN COMPOSITION FOR SEALING ORGANIC ELECTRONICS DEVICES AND ORGANIC ELECTRONICS DEVICE**
HARZZUSAMMENSETZUNG ZUR ABDICHTUNG ORGANISCHER ELEKTRONISCHER VORRICHTUNGEN UND ORGANISCHE ELEKTRONISCHE VORRICHTUNG
COMPOSITION DE RÉSINE POUR LE SCELLEMENT DE DISPOSITIFS ÉLECTRONIQUES ORGANIQUES ET DISPOSITIF ÉLECTRONIQUE ORGANIQUE

(30) Priority: 10.12.2012 JP 2012269669
(43) Date of publication of application: 14.10.2015
(73) Proprietor: Zeon Corporation, Tokyo 100-8246 (JP)
(72) Inventor: TAZAKI, Satoshi, Tokyo 100-8246 (JP); KASHIWAGI, Motofumi, Tokyo 100-8246 (JP); ISHIGURO, Atsushi, Tokyo 100-8246 (JP); KOIDE, Yohei, Tokyo 100-8246 (JP)
(74) Representative: Maiwald GmbH
(86) International application number: PCT/JP2013/082103
(87) International publication number: WO 2014/091941

(56) References cited:
- EP-A1- 2 623 526
- WO-A1-2009/151029
- WO-A1-2009/151029
- WO-A1-2011/096389
- JP-A- 2005 129 520
- JP-A- 2005 322 599
- JP-A- 2010 045 016
- JP-A- 2010 083 979
- JP-A- 2010 160 906

## Description

### Field

The present invention relates to an organic electronic device sealing resin composition and an organic electronic device.

### Background

In an organic electronic device including an element such as an organic electroluminescent element (this may be appropriately referred to hereinbelow as an "organic EL element") and an organic semiconductor element, a sealing member is sometimes provided. By providing such a sealing member in a manner of sealing an organic material inside the device, deterioration of the organic material due to water vapor and oxygen can be prevented, and decrease in performance of the device can be prevented.

As such a sealing member, there is known materials such as a flexible material containing a styrenebased elastomer (Patent Literature 1) and an epoxy-based material (Patent Literature 2). Use of a member composed of such a flexible resin as a sealing member can achieve sealing of the element, and also can cover the irregular structure of the device with the resin. Thus, the strength of the device can be enhanced. A transparent sealing material for organic EL device is described in Patent Literature 3.

### Citation List

### Patent Literature

[Patent Literature 1] Japanese Patent Application Laid-Open No. 2005-129520 A (corresponding application publications: EP Patent Application Publication No. 1670292 and US Patent Application Publication No. 2008/220245)
[Patent Literature 2] Japanese Patent Application Laid-Open No. 2006-183002 A
[Patent Literature 3] European Patent Application EP 1 670 292 A1

### Summary

### Technical Problem

However, existing sealing members have a problem in that the amount of degassing increases after a layer of the sealing member is formed. Such a degassing phenomenon can become an obstacle in the operation for producing the device after the formation of the sealing member layer. Further, when a gas which has been discharged outside the sealing member due to the degassing enters the element, deterioration of the organic material can be caused.

Therefore, an object of the present invention is to provide an organic electronic device sealing resin composition that does not cause a large amount of degassing and achieves favorable sealing.

A further object of the present invention is to provide an organic electronic device including a favorably sealed organic material and exhibiting excellent performance in, e.g., durability with the lapse of time.

### Solution to Problem

The present inventor has conducted research in order to solve the aforementioned problem, and as a result, found out that the aforementioned problem can be solved by adopting a composition as defined in claim 1 and containing a certain block copolymer hydride as a sealing composition. Thus, the present invention has been accomplished.

That is, according to the present invention, the following is provided.
(1) Use of resin composition comprising a block copolymer hydride obtained by hydrogenating 90% or more of all unsaturated bonds of a block copolymer and a plasticizer at 1 to 50 parts by weight with respect to 100 parts by weight of the block copolymer hydride,
   wherein the block copolymer includes: two or more polymer blocks [A] per one molecule of the copolymer, the block having an aromatic vinyl compound unit as a main component; and
   one or more polymer blocks [B] per one molecule of the copolymer, the block having a linear conjugated diene compound unit as a main component, and
   a ratio between a weight fraction wA of all the polymer blocks [A] in the entire block copolymer and a weight fraction wB of all the polymer blocks [B] in the entire block copolymer (wA:wB) is 20:80 to 60:40, and
   wherein the plasticizer is a hydrocarbon polymer having a number average molecular weight of 200 to 5000, for sealing an organic electronic device.
(2) The use according to (1), wherein a weight average molecular weight of the block copolymer hydride is 30,000 to 200,000.
(3) The use according to (1) or (2), wherein the block copolymer is a triblock copolymer in which the polymer blocks [A] are bonded to both ends of the polymer block [B].
(4) The use according to any one of (1) to (3), wherein the block copolymer hydride has an alkoxysilyl group.
(5) The use according to any one of (1) to (4), wherein the polymer block [A] contains the aromatic vinyl compound unit at 90% by weight or more, and the polymer block [B] contains the linear conjugated diene compound unit at 90% by weight or more.
(6) The use according to any one of (1) to (5), wherein the amount of the plasticizer is at 5 to 50 parts by weight with respect to 100 parts by weight of the block copolymer hydride.
(7) The use according to any one of (1) to (6), wherein the number average molecular weight of the hydrocarbon polymer as the plasticizer is 300 to 3000.
(8) An organic electronic device comprising:
   an element containing an organic material; and
   a layer of the resin composition according to any one of (1) to (7).
(9) The organic electronic device according to (8), further comprising an absorbent layer lying between the element and the layer of the resin composition.
(10) The organic electronic device according to (8) or (9), further comprising a temporary sealing layer lying between the element and the layer of the resin composition. Advantageous Effects of Invention

According to the organic electronic device sealing resin composition used in the present invention, as defined in claim 1, favorable sealing in an organic electronic device can be achieved with reduced degassing.

In the organic electronic device of the present invention, as defined in claim 8, the organic material that constitutes the device is favorably sealed. Accordingly, deterioration of the device is thereby suppressed, and the device exhibits excellent performance in, e.g., durability with the lapse of time.

### Brief Description of Drawings

Fig. 1 is a perspective view schematically illustrating an assembly constituting an organic electronic device that contains components such as an organic EL element.
Fig. 2 is a vertical sectional view schematically illustrating an example of an organic electronic device that includes the assembly illustrated in Fig. 1 and a layer of a sealing resin composition.
Fig. 3 is a vertical sectional view schematically illustrating another example of the organic electronic device according to the present invention.
Fig. 4 is a vertical sectional view schematically illustrating still another example of the organic electronic device according to the present invention.
Fig. 5 is a vertical sectional view schematically illustrating still another example of the organic electronic device according to the present invention, containing components such as an organic semiconductor.

### Description of Embodiments

Although the present invention will be described in detail hereinbelow by illustrating embodiments and examples, the present invention is not limited to the following embodiments and examples.

### [1. Block Copolymer]

The block copolymer used in the present invention includes two or more polymer blocks [A] per one molecule of the copolymer, the block having an aromatic vinyl compound unit as a main component; and one or more polymer blocks [B] per one molecule of the copolymer, the block having a linear conjugated diene compound unit as a main component.

The aromatic vinyl compound unit possessed by the polymer block [A] is a unit obtained by polymerizing an aromatic vinyl compound. Examples of the aromatic vinyl compound may include styrene, α-methylstyrene, 2-methylstyrene, 3-methylstyrene, 4-methylstyrene, 2,4-diisopropylstyrene, 2,4-dimethylstyrene, 4-t-butylstyrene, 5-t-butyl-2-methylstyrene, 4-monochlorostyrene, dichlorostyrene, 4-monofluorostyrene, and 4-phenylstyrene. One type of these may be used alone, or two or more types thereof may be used in combination at any ratio. Among these, the compound not containing a polar group is preferable in consideration of hygroscopicity. Furthermore, styrene is particularly preferable from the viewpoint of industrial availability and impact resistance.

The content ratio of the aromatic vinyl compound unit in the polymer block [A] is usually 90% by weight or more, preferably 95% by weight or more, and more preferably 99% by weight or more. When the amount of the aromatic vinyl compound unit in the polymer block [A] is such a large amount, the layer of the sealing resin composition can have enhanced heat resistance. The upper limit of the content ratio of the aromatic vinyl compound unit in the polymer block [A] may be 100% by weight or less.

The polymer block [A] may contain a component other than the aromatic vinyl compound unit. Examples of the component other than the aromatic vinyl compound unit may include a linear conjugated diene compound unit and a structural unit having a structure formed by polymerizing a vinyl compound other than the aromatic vinyl compound.

Examples of a linear conjugated diene compound corresponding to the linear conjugated diene compound unit may include 1,3-butadiene, isoprene, 2,3-dimethyl-1,3-butadiene, and 1,3-pentadiene. One type of these may be used alone, or two or more types thereof may be used in combination at any ratio. Among these, the compound not containing a polar group is preferable in consideration of hygroscopicity. Specifically, 1,3-butadiene and isoprene are particularly preferable.

Examples of the vinyl compound other than the aromatic vinyl compound may include a linear vinyl compound; a cyclic vinyl compound; a vinyl compound having a nitrile group, an alkoxycarbonyl group, a hydroxycarbonyl group, or a halogen group; an unsaturated cyclic acid anhydride; and an unsaturated imide compound. Preferred examples thereof are compounds not containing a polar group in consideration of hygroscopicity. Examples thereof may include linear olefins such as ethylene, propylene, 1-butene, 1-pentene, 1-hexene, 1-heptene, 1-octene, 1-nonene, 1-decene, 1-dodecene, 1-eicosene, 4-methyl-1-pentene, and 4,6-dimethyl-1-heptene; and cyclic olefins such as vinylcyclohexane. Among these, linear olefins are more preferable, and ethylene and propylene are particularly preferable. One type of these may be used alone, or two or more types thereof may be used in combination at any ratio.

The content ratio of the component other than the aromatic vinyl compound unit in the polymer block [A] is usually 10% by weight or less, preferably 5% by weight or less, and more preferably 1% by weight or less. The lower limit of the content ratio of the component other than the aromatic vinyl compound unit in the polymer block [A] may be 0% by weight or more.

The number of polymer blocks [A] per one molecule of the block copolymer is usually 2 or more, and usually 5 or less, preferably 4 or less, and more preferably 3 or less. A plurality of polymer blocks [A] present in one molecule may be the same as each other, or may be different from each other.

The linear conjugated diene compound unit possessed by the polymer block [B] is a unit obtained by polymerizing a linear conjugated diene compound. Examples of the linear conjugated diene compound may be the same as those listed for the optional components of the polymer block [A].

The content ratio of the linear conjugated diene compound unit in the polymer block [B] is usually 90% by weight or more, preferably 95% by weight or more, and more preferably 99% by weight or more. When the amount of the linear conjugated diene compound unit in the polymer block [B] is such a large amount, a layer of the sealing resin composition can have improved impact resistance at low temperature. The upper limit of the linear conjugated diene compound unit in the polymer block [B] may be 100% by weight or less.

Further, the polymer block [B] may contain a component other than the linear conjugated diene compound unit. Examples of the component other than the linear conjugated diene compound unit may include an aromatic vinyl compound unit, and a structural unit having a structure formed by polymerizing a vinyl compound other than the aromatic vinyl compound. Examples of the aromatic vinyl compound unit and the structural unit having a structure formed by polymerizing a vinyl compound other than the aromatic vinyl compound may be the same as those listed for the optional components of the polymer block [A] .

The content ratio of the component other than the linear conjugated diene compound unit in the polymer block [B] is usually 10% by weight or less, preferably 5% by weight or less, and more preferably 1% by weight or less. In particular, by setting the content ratio of the aromatic vinyl compound unit in the polymer block [B] at a low value, flexibility of the layer of the sealing resin composition at low temperature can be improved, and impact resistance of the layer of the sealing resin composition at low temperature can thereby be improved. The lower limit of the content ratio of the component other than the linear conjugated diene compound unit in the polymer block [B] may be 0% by weight or more.

The number of polymer blocks [B] per one molecule of the block copolymer may be usually one or more, but may also be two or more. When the number of polymer blocks [B] in the block copolymer is two or more, the polymer blocks [B] may be the same as each other, or may be different from each other.

The form of the blocks of the block copolymer may be a linear-type block or a radial-type block. Of these, the linear-type block has excellent mechanical strength, and is thus preferable.

When the copolymer is in the form of the linear-type block, it is preferable that both ends thereof are the blocks [A], since thereby stickiness of the sealing resin composition can be suppressed to a desired low value and the copolymer can express the function as a sealing resin composition.

Particularly preferred forms of the block copolymer are a triblock copolymer in which the polymer blocks [A] are bonded to both ends of the polymer block [B]; and a pentablock copolymer in which the polymer blocks [B] are bonded to both ends of the polymer block [A], and the other end of each of the both polymer blocks [B] is further bonded to another polymer block [A]. In particular, the triblock copolymer of [A]-[B]-[A] is particularly preferable, since manufacture thereof can be easily performed, and physical properties thereof such as viscosity can be set within a desired range.

In the block copolymer, a ratio between a weight fraction wA of all the polymer blocks [A] in the entire block copolymer and a weight fraction wB of all the polymer blocks [B] in the entire block copolymer (wA:wB) is 20:80 to 60:40, and preferably 30:70 to 55:45. When the ratio of wA is set to be not less than the lower limit of the aforementioned range, the layer of the sealing resin composition can have improved heat resistance. When the ratio of wA is set to be not more than the upper limit value, the layer of the sealing resin composition can have increased flexibility to stably and favorably maintain gas barrier property of the layer of the sealing resin composition. Furthermore, Tg is decreased and the sealing temperature is thereby decreased, so that damage to, e.g., an organic EL element is reduced.

When different polymer blocks [A] or polymer blocks [B] exist in one molecule of the block copolymer, the weight average molecular weights of the polymer block having a maximum weight average molecular weight and the polymer block having a minimum weight average molecular weight of the polymer blocks [A] are defined as Mw(A1) and Mw(A2), respectively. Also, the weight average molecular weights of the polymer block having a maximum weight average molecular weight and the polymer block having a minimum weight average molecular weight of the polymer blocks [B] are defined as Mw(B1) and Mw(B2), respectively. In this case, a ratio "Mw(A1)/Mw(A2)" between Mw(A1) and Mw(A2) and a ratio "Mw(B1)/Mw(B2)" between Mw(B1) and Mw(B2) are each preferably 2.0 or less, preferably 1.5 or less, and particularly preferably 1.2 or less. This can suppress variations of various physical properties. The lower limit of these ratios may be 1.0 or more.

The molecular weight of the block copolymer, in terms of polystyrene equivalent weight average molecular weight (Mw) measured by GPC using tetrahydrofuran (THF) as a solvent, is usually 30,000 or more, preferably 40,000 or more, and more preferably 50,000 or more, and is usually 200,000 or less, preferably 150,000 or less, and more preferably 100,000 or less. The molecular weight distribution (Mw/Mn) of the block copolymer is preferably 3 or less, more preferably 2 or less, and particularly preferably 1.5 or less. The lower limit of these ratios may be 1.0 or more.

In an instance of producing a block copolymer having three polymer blocks, examples of the method for producing the block copolymer may include the following methods.

(Production Method 1) A method including:
a first step of polymerizing a monomer mixture (a1) containing an aromatic vinyl compound to form a polymer block [A];
a second step of polymerizing a monomer mixture (b1) containing a linear conjugated diene compound on one end of the polymer block [A] to form a polymer block [B], to form a diblock polymer of [A]-[B]; and
a third step of polymerizing a monomer mixture (a2) containing an aromatic vinyl compound (the monomer mixture (a1) and the monomer mixture (a2) may be the same as or different from each other) at the end on the block [B] side of the diblock, to obtain a block copolymer.

(Production Method 2) A method including:
a first step of polymerizing a monomer mixture (a1) containing an aromatic vinyl compound to form a polymer block [A];
a second step of polymerizing a monomer mixture (b1) containing a linear conjugated diene compound on one end of the polymer block [A] to form a polymer block [B], to form a diblock polymer of [A]-[B]; and
a third step of coupling ends on the polymer block [B] side of the diblock polymers with each other using a coupling agent, to obtain a block copolymer.

Examples of the method for polymerizing the aforementioned monomer mixtures to obtain the polymer blocks may include radical polymerization, anionic polymerization, cationic polymerization, coordinate anionic polymerization, and coordinate cationic polymerization. From the viewpoint of facilitating polymerization operation and hydrogenation reaction in subsequent steps, it is preferable that radical polymerization, anionic polymerization and cationic polymerization, etc. are performed through living polymerization. Living anionic polymerization is particularly preferably performed.

The aforementioned polymerization of the monomer mixtures is performed in the presence of a polymerization initiator in a temperature range of usually 0°C or higher, preferably 10°C or higher, and more preferably 20°C or higher, and usually 100°C or lower, preferably 80°C or lower, and more preferably 70°C or lower.

Examples of the polymerization initiator for use in living anionic polymerization may include mono-organic lithium such as n-butyl lithium, sec-butyl lithium, t-butyl lithium, and hexyl lithium; and polyfunctional organic lithium compounds such as dilithiomethan, 1,4-dilithiobutane, and 1,4-dilithio-2-ethylcyclohexane. One type of these may be used alone, or two or more types thereof may be used in combination at any ratio.

The form of the polymerization reaction may be any one of solution polymerization, slurry polymerization, etc. Among these, use of the solution polymerization facilitates removal of reaction heat.

When the solution polymerization is performed, an inert solvent in which the polymer obtained in each step can be dissolved is used as the solvent. Examples of the inert solvent may include aliphatic hydrocarbons such as n-pentane, isopentane, n-hexane, n-heptane, and isooctane; alicyclic hydrocarbons such as cyclopentane, cyclohexane, methylcyclopentane, methylcyclohexane, and decalin; and aromatic hydrocarbons such as benzene and toluene. One type of these may be used alone, or two or more types thereof may be used in combination at any ratio. Among these, alicyclic hydrocarbons are preferable, because they can also be used as they are as an inert solvent in the hydrogenation reaction, and has favorable solubility of the block copolymer. Using amount of the solvent with respect to 100 parts by weight of all monomers used is usually 200 parts by weight to 2000 parts by weight.

When each monomer mixture contains two or more types of monomers, e.g., a randomizer may be used in order to prevent elongation of only a chain of certain one component. In particular, when the polymerization reaction is performed through anionic polymerization, e.g., a Lewis base compound is preferably used as the randomizer. Examples of the Lewis base compound may include ether compounds such as dimethyl ether, diethyl ether, diisopropyl ether, dibutyl ether, tetrahydrofuran, diphenyl ether, ethylene glycol diethyl ether, and ethylene glycol methyl phenyl ether; tertiary amine compounds such as tetramethylethylenediamine, trimethylamine, triethylamine, and pyridine; alkali metal alkoxide compounds such as potassium-t-amyloxide and potassium-t-butyloxide; and phosphine compounds such as triphenylphosphine. One type of these may be used alone, or two or more types thereof may be used in combination at any ratio.

### [2. Block Copolymer Hydride]

The sealing resin composition according to the present invention contains a block copolymer hydride. The block copolymer hydride is obtainable by hydrogenating 90% or more of all unsaturated bonds of the aforementioned specific block copolymer.

The all unsaturated bonds of the block copolymer block refers to a total of aromatic and non-aromatic carbon-carbon unsaturated bonds of the main and side chains of the block copolymer. The hydrogenation ratio is 90% or more, preferably 97% or more, and more preferably 99% or more. By having a higher hydrogenation ratio, the sealing resin composition can have better heat resistance and light resistance. The hydrogenation ratio of the hydride herein may be determined by measurement with ¹H-NMR. The upper limit of the hydrogenation ratio may be set to 100% by weight or less.

In particular, the hydrogenation ratio of the non-aromatic unsaturated bonds is preferably 95% or more, and more preferably 99% or more. When the hydrogenation ratio of the non-aromatic carbon-carbon unsaturated bonds is increased, the sealing resin composition can have further improved light resistance and oxidation resistance. The upper limit of the hydrogenation ratio may be set to 100% by weight or less.

The hydrogenation ratio of the aromatic carbon-carbon unsaturated bonds is preferably 90% or more, more preferably 93% or more, and particularly preferably 95% or more. When the hydrogenation ratio of the carbon-carbon unsaturated bonds of aromatic rings is increased, the glass transition temperature of the polymer block obtained by hydrogenating the polymer block [A] becomes higher. Accordingly, the layer of the sealing resin composition can have effectively enhanced heat resistance. The upper limit of the hydrogenation ratio may be set to 100% by weight or less.

The block copolymer hydride may have an alkoxysilyl group. The block copolymer hydride having the alkoxysilyl group may be manufactured by, after the hydrogenation reaction of the block copolymer, performing operation for modification of the reaction product with alkoxysilane as necessary to introduce an alkoxysilyl group.

The alkoxysilyl group may be bonded to the aforementioned block copolymer hydride directly or via a divalent organic group such as an alkylene group. As the method for introducing the alkoxysilyl group, a method wherein the aforementioned block copolymer hydride is reacted with an ethylenic unsaturated silane compound in the presence of a peroxide may usually be employed. An excess introduction amount of the alkoxysilyl group causes a problem that the crosslinking degree between the alkoxysilyl groups decomposed by a trace amount of moisture becomes higher to thereby likely reduce the adhesion with an object to be sealed. From this viewpoint, if a block copolymer hydride having an alkoxysilyl group is used as the block copolymer hydride, the introduction amount of the alkoxysilyl group with respect to the weight of the block copolymer hydride before the introduction of such a group is usually 0.1 to 10 g/100 g, preferably 0.2 to 5 g/100 g, and more preferably 0.3 to 3 g/100 g. The introduction amount of the alkoxysilyl group is calculated by a ¹H-NMR spectrum (when the introduction amount is small, the number of integrations is increased).

The ethylenic unsaturated silane compound is not particularly limited, and may be appropriately selected from the compounds that can be graft-polymerized with the aforementioned block copolymer hydride to introduce the alkoxysilyl group to the block copolymer hydride. Examples of the ethylenic unsaturated silane compound may include one or more types selected from ethylenic unsaturated silane compounds such as vinyltrimethoxysilane, vinyltriethoxysilane, allyltrimethoxysilane, allyltriethoxysilane, dimethoxymethylvinylsilane, diethoxymethylvinylsilane, p-styryltrimethoxysilane, p-styryltriethoxysilane, 3-methacryloxypropyltrimethoxysilane, 3-methacryloxypropylmethyldimethoxysilane, 3-methacryloxypropyltriethoxysilane, 3-methacryloxypropylmethyldiethoxysilane, 3-acryloxypropyltrimethoxysilane, 3-acryloxypropyltriethoxysilane, and 2-norbornene-5-yltrimethoxysilane. In the present invention, among these, vinyltrimethoxysilane, vinyltriethoxysilane, allyltrimethoxysilane, allyltriethoxysilane, dimethoxymethylvinylsilane, diethoxymethylvinylsilane, and p-styryltrimethoxysilane are suitably used.

One type of these ethylenic unsaturated silane compounds may be used alone, or two or more types thereof may be used in combination. Using amount of the ethylenic unsaturated silane compound with respect to 100 parts by weight of the block copolymer hydride is usually 0.1 to 10 parts by weight, preferably 0.2 to 5 parts by weight, and more preferably 0.3 to 3 parts by weight.

Examples of the peroxide for use may include one or more types selected from organic peroxides such as dibenzoyl peroxide, t-butyl peroxyacetate, 2,2-di-(t-butyl peroxy)butane, t-butyl peroxybenzoate, t-butyl cumyl peroxide, dicumyl peroxide, di-t-hexyl peroxide, 2,5-dimethyl-2,5-di(t-butylperoxy hexane), di-t-butyl peroxide, 2,5-dimethyl-2,5-di(t-butyl peroxy)hexane-3, t-butyl hydroperoxide, t-butyl peroxyisobutyrate, lauroyl peroxide, dipropionyl peroxide, and p-menthane hydroperoxide. In the present invention, among these, a peroxide having a oneminute half-life temperature of 170 to 190°C is preferably used. Suitable examples thereof may include t-butyl cumyl peroxide, dicumyl peroxide, di-t-hexyl peroxide, 2,5-dimethyl-2,5-di(t-butylperoxy hexane), and di-t-butyl peroxide.

One type of these peroxides may be used alone, or two or more types thereof may be used in combination. Using amount of the peroxide with respect to 100 parts by weight of the block copolymer hydride is usually 0.01 to 5 parts by weight, preferably 0.2 to 3 parts by weight, and more preferably 0.3 to 2 parts by weight.

The aforementioned method of reacting the block copolymer hydride with the ethylenic unsaturated silane compound in the presence of the peroxide may be performed using a heating kneader or a reaction vessel. For example, denaturation may be effected by heating and melting a mixture of the block copolymer hydride, the ethylenic unsaturated silane compound, and the peroxide in a biaxial kneader at a temperature equal to or higher than the melting temperature of the block copolymer, and kneading the product for a desired period of time. With the block copolymer according to the present invention, the temperature for the process is usually 180 to 240°C, preferably 190 to 230°C, and more preferably 200 to 220°C. The heating and kneading time is usually approximately 0.1 to 15 minutes, preferably approximately 0.2 to 10 minutes, and more preferably approximately 0.3 to 5 minutes. When using continuous kneading facilities such as a biaxial kneader and a monoaxis extruder, kneading and extrusion may be continuously performed with a retention time set within the aforementioned range.

Since the amount of the introduced alkoxysilyl group is small, the molecular weight of the block copolymer hydride having the alkoxysilyl group is not largely changed from that of the block copolymer hydride before the introduction of the alkoxysilyl group. However, since a denaturation reaction is performed in the presence of peroxide, a crosslinking reaction and a scission reaction of the polymer are also caused. Therefore, the molecular weight distribution becomes larger. The molecular weight of the block copolymer hydride having the alkoxysilyl group, in terms of a polystyrene equivalent weight average molecular weight (Mw) measured by gel permeation chromatography (GPC) using tetrahydrofuran as a solvent, is usually (30,000 to 200,000), preferably (40,000 to 150,000), and more preferably (50,000 to 120,000). The molecular weight distribution (Mw/Mn) is usually 3.5 or less, preferably 2.5 or less, and particularly preferably 2.0 or less. The lower limit of Mw/Mn may be set to 1.0 or more. When Mw and Mw/Mn fall within the range, favorable mechanical strength and tensile elongation of the sealing resin composition according to the present invention can be maintained. The denatured polymer obtained in the aforementioned manner has improved adhesion with materials such as glass, inorganic matters, and metal. When such a polymer is used for a sealing layer of an organic electronic device, adhesion with other layers such as a temporary sealing layer increases. Therefore, even after the exposure to a high temperature and high humidity environment for an extended period of time, which is usually performed in a reliability evaluation of an organic electronic device, the denatured polymer can maintain sufficient adhesion, and is thus preferably used.

The specific hydrogenation method is not limited so long as a desired hydride can be obtained. A hydrogenation method that increases the hydrogenation ratio with small degree of chain scission reaction is preferably employed. Examples of such a preferred hydrogenation method may include a method using a hydrogenation catalyst containing at least one type of metal selected from the group consisting of nickel, cobalt, iron, titanium, rhodium, palladium, platinum, ruthenium, and rhenium. As the hydrogenation catalyst, any one of a non-homogeneous catalyst and a homogeneous catalyst may be used. The hydrogenation reaction is preferably performed in an organic solvent.

The non-homogeneous catalyst may be used in a form of, e.g., metal or a metal compound as it is, or in a state of being supported on an appropriate carrier. Examples of the carrier may include activated carbon, silica, alumina, calcium carbonate, titania, magnesia, zirconia, diatomaceous earth, silicon carbide, and calcium fluoride. The supported amount of the catalyst with respect to a total amount of the catalyst and the carrier is usually 0.1% by weight or more, and preferably 1% by weight or more, and is usually 60% by weight or less, and preferably 50% by weight or less. The specific surface area of the supported-type catalyst is preferably 100 m²/g to 500 m²/g. Furthermore, the average pore size of the supported-type catalyst is preferably 100 angstroms or more, and more preferably 200 angstroms or more, and is preferably 1000 angstroms or less, and preferably 500 angstroms or less. The specific surface area herein is obtained by measuring a nitrogen adsorption amount and using the BET equation. The average pore size may be measured by a mercury intrusion method.

Examples of the homogeneous catalyst may include a catalyst that is a combination of a nickel, cobalt, titanium or iron compound and an organic metal compound; and an organic metal complex catalyst of, e.g., rhodium, palladium, platinum, ruthenium, or rhenium.

Examples of the nickel, cobalt, titanium or iron compound may include an acetylacetonate compound, a carboxylic acid salt and a cyclopentadienyl compound of each metal.

Examples of the organic metal compound may include an organic aluminum compound and an organic lithium compound. Examples of the organic aluminum compound may include alkyl aluminum such as triethylaluminum and triisobutyl aluminum, aluminum halide such as diethyl aluminum chloride and ethyl aluminum dichloride, and hydrogenated alkyl aluminum such as diisobutyl aluminum hydride.

Examples of the organic metal complex catalyst may include transition metal complexes such as dihydridetetrakis(triphenylphosphine)ruthenium, dihydridetetrakis(triphenylphosphine)iron, bis(cyclooctadiene)nickel, and bis(cyclopentadienyl)nickel.

One type of these hydrogenation catalysts may be used alone, or two or more types thereof may be used in combination at any ratio.

Using amount of the hydrogenation catalyst with respect to 100 parts by weight of the block copolymer is usually 0.01 parts by weight or more, preferably 0.05 parts by weight or more, and more preferably 0.1 parts by weight or more, and is usually 100 parts by weight or less, preferably 50 parts by weight or less, and more preferably 30 parts by weight or less.

The temperature of the hydrogenation reaction is usually 10°C or higher, preferably 50°C or higher, and more preferably 80°C or higher, and is usually 250°C or lower, preferably 200°C or lower, and more preferably 180°C or lower. When the temperature is in that range, the hydrogenation ratio becomes higher, and scission of a molecule is reduced. The hydrogen pressure during the hydrogenation reaction is usually 0.1 MPa or more, preferably 1 MPa or more, and more preferably 2 MPa or more, and is usually 30 MPa or less, preferably 20 MPa or less, and more preferably 10 MPa or less. When the hydrogen pressure is in this range, the hydrogenation ratio becomes higher, scission of a molecular chain is reduced, and operability becomes excellent.

The product as it is after the hydrogenation reaction may be used as the block copolymer hydride for use in the present invention. Alternatively, the product after the hydrogenation reaction may be subjected to an optional operation as necessary, to obtain the block copolymer hydride for use in the present invention. For example, the product after the hydrogenation reaction may be subjected to a denaturation operation with alkoxysilane as necessary.

The block copolymer hydride obtained in the aforementioned method may be recovered from the reaction solution after removing the hydrogenation catalyst and the polymerization catalyst from the reaction solution containing the hydride by a method such as filtration and centrifugation. Examples of the method for recovering the hydride from the reaction solution may include a steam coagulation process of removing a solvent from the solution in which the hydride is dissolved by steam tripping; a direct desolvation process of removing the solvent under reduced pressure and heating; and a coagulation process of pouring a solution into a poor solvent for the hydride to bring about deposition and coagulation.

Although the form of the recovered block copolymer hydride is not limited to particular ones, pellets are usually used for facilitating handling in the subsequent molding process or denaturation reaction. When using the hydride recovered from the reaction solution by the direct desolvation process, e.g., the hydride in a molten state may be extruded into a strand shape through a dice, and cooled. Then, the cooled product may be cut into pellets using a pelletizer for use in a variety of molding. Also, when using the coagulation process, e.g., the obtained coagulated product may be dried, and thereafter extruded in a molten state using an extruder and then, in the similar manner to the aforementioned method, cut into pellets for use in a variety of molding.

The molecular weight of the block copolymer hydride, in terms of a polystyrene equivalent weight average molecular weight (Mw) measured by gel permeation chromatography (GPC) using tetrahydrofuran as a solvent, is usually 30,000 or more, preferably 40,000 or more, and more preferably 45,000 or more, and is usually 200,000 or less, preferably 150,000 or less, and more preferably 100,000 or less. The molecular weight distribution (Mw/Mn) of the block copolymer hydride is preferably 3 or less, more preferably 2 or less, and particularly preferably 1.5 or less. When the molecular weight and molecular weight distribution of the hydride are set to be within the aforementioned ranges, the layer of the sealing resin composition can have improved mechanical strength and heat resistance.

Although the ratio (wA:wB) between the weight fraction wA of all the polymer blocks [A] in the entire block copolymer and the weight fraction wB of all the polymer blocks [B] in the entire block copolymer in the block copolymer hydride is not particularly limited, it usually has a similar value to that of wA:wB in the block copolymer.

### [3. Other Components]

The sealing resin composition used according to the present invention may include optional components in addition to the aforementioned specific block copolymer hydride.

Examples of the optional components that may be contained in the sealing resin composition may include plasticizers for improving adhesion, weather resistance, heat resistance, etc., light stabilizers, ultraviolet absorbers, antioxidants, lubricants, and inorganic fillers. One type of these may be used alone, or two or more types thereof may be used in combination at any ratio.

Suitable examples of the plasticizers may include oligomers other than the block copolymer hydride; organic acid ester-based plasticizers such as monobasic organic acid esters and polybasic organic acid esters; and phosphorus acid ester-based plasticizers such as organic phosphoric acid ester-based and organic phosphorous acid ester-based plasticizers. These plasticizers may be used singly or in any combination of two or more.

As the oligomer, those which can be uniformly dissolved or dispersed in the block copolymer hydride are preferable. A hydrocarbon polymer having a number average molecular weight of 200 to 5,000, and more preferably 300 to 3,000 is present in the resin composition since therewith heat resistance is not significantly impaired. Specific examples of the hydrocarbon polymer may include polyisobutylene, polybutene, poly-4-methylpentene, poly-1-octene, ethylene·α-olefin copolymers, polyisoprene, alicyclic hydrocarbon resins, other aliphatic hydrocarbon resins, hydrides of the aforementioned compounds, and indene-styrene copolymer hydrides. Among these, polyisobutylene, polybutene, hydrogenated polyisobutylene, and hydrogenated polybutene are preferable.

Examples of the organic acid ester-based plasticizers may include glycol-based esters obtained by a reaction of glycol such as triethylene glycol, tetraethylene glycol, and tripropylene glycol with a monobasic acid such as butyric acid, isobutyric acid, caproic acid, 2-ethylbutyric acid, heptanoic acid, heptylic acid, n-octylic acid, 2-ethylhexyl acid, pelargonic acid (n-nonylic acid) and decylic acid; and polybasic acid esters obtained by a reaction of a polybasic acid such as adipic acid, sebacic acid, azelaic acid, and phthalic acid with a liner or branched alcohol having 4 to 8 carbons per molecule. Among these, butyl benzyl phthalate, dibenzyl phthalate, etc. are preferable.

Examples of the phosphorus acid ester-based plasticizers may include tributoxyethyl phosphate, tri(2-ethylhexyl)phosphate, tricresyl phosphate, and isodecyldiphenyl phosphate. Among these, tricresyl phosphate, trixylenyl phosphate, etc. are preferable, because therewith the refractive index of the adhesive resin composition layer becomes closer to the refractive index of float glass so that a laminated glass plate having excellent light transmittance is obtained.

The adding amount of the hydrocarbon polymer as plasticizer with respect to 100 parts by weight of the block copolymer hydride is 1 to 50 parts by weight, and more preferably 5 to 40 parts by weight. When the adding amount is less than 1 part by weight, plasticization effects become small. Accordingly, air bubbles are likely to remain on glass plates that are attached to each other with the sealing resin composition layer containing the block copolymer hydride interposed therebetween. Thus, conditions such as bonding at a higher temperature may be required to be set in some cases. Also, when the adding amount exceeds 50 parts by weight, bleedout of the plasticizer may be caused and adhesion with glass may be reduced.

The light stabilizer is preferably a hindered amine-based light stabilizer, and particularly preferably a compound having, e.g., a 3,5-di-t-butyl-4-hydroxyphenyl group, a 2,2,6,6-tetramethylpiperidyl group, a 1,2,2,6,6-pentamethyl-4-piperidyl group in the structure.

Specific examples of the light stabilizers may include a mixed esterified product of 1,2,3,4-butanetetracarboxylic acid, 1,2,2,6,6-pentamethyl-4-piperidinol, and 3,9-bis(2-hydroxy-1,1-dimethylethyl)-2,4,8,10-tetraoxaspiro[5,5]undecane, a polycondensate of 1,6-hexanediamine-N,N'-bis(2,2,6,6-tetramethyl-4-piperidyl) and morpholine-2,4,6-trichloro-1,3,5-triazine, 1-[2-[3-(3,5-di-t-butyl-4-hydroxyphenyl)propionyloxy]ethyl]-4-[3-3,5-di-t-butyl-4-hydroxyphenyl)propionyloxy]-2,2,6,6-tetramethylpiperidine, 2-(3,5-di-t-butyl-4-hydroxybenzyl)-2-n-butylmalonic acid-bis-(1,2,2,6,6-pentamethyl-4-piperidyl), 2-(3,5-di-t-butyl-4-hydroxybenzyl)-2-n-butylmalonic acid-bis-(1,2,2,6,6-pentamethyl-4-piperidyl), 4-(3-(3,5-di-t-butyl-4-hydroxyphenyl)propionyloxy)-1-(2-(3-(3,5-di-t-butyl-4-hydroxyphenyl)propionyloxy)ethyl)-2,2,6,6-tetramethylpiperidine, 4-(N-(1-benzyl-2-phenylethyl)-N-formylamino)-2,2,6,6-tetramethylpiperidine, 4-(N-(2-(1-pyrrolidyl)ethyl)-N-formylamino)-2,2,6,6-tetramethylpiperidine, 4-(N-(2-(4-morpholinyl)ethyl)-N-formylamino)-2,2,6,6-tetramethyl-N-methylpiperidine, 4-(N-(2-(4-morpholinyl)ethyl)-N-formylamino)-2,2,6,6-tetramethylpiperidine, 4-(N-(2-(diisopropylamino)ethyl)-N-formylamino)-2,2,6,6-tetramethylpiperidine, 4-(N-(2,4,6-trimethylbenzyl)-N-formylamino)-2,2,6,6-tetramethylpiperidine, 4-(N-(3-(2-ethylhexoxy)propyl)-N-formylamino)-2,2,6,6-tetramethylpiperidine, 4-(N-(3,4-(methylenedioxy)benzyl)-N-formylamino)-2,2,6,6-tetramethylpiperidine, 4-(N-(bicyclo[2.2.1]heptyl)-N-formylamino)-2,2,6,6-tetramethylpiperidine, 4-(N-1,2,2-trimethylpropyl-N-formylamino)-2,2,6,6-tetramethylpiperidine, 4-(N-1,3-dimethylbutyl-N-formylamino)-2,2,6,6-tetramethylpiperidine, 4-(N-1-benzylethyl-N-formylamino)-2,2,6,6-tetramethylpiperidine, 4-(N-2,2-dimethylpropyl-N-formylamino)-2,2,6,6-tetramethylpiperidine, 4-(N-2-ethylhexyl-N-formylamino)-2,2,6,6-tetramethylpiperidine, 4-(N-3-methylbutyl-N-formylamino)-2,2,6,6-tetramethylpiperidine, 4-(N-4-hydroxybutyl-N-formylamino)-2,2,6,6-tetramethylpiperidine,
4-(N-4-hydroxybutyl-N-formylamino)-2,2,6,6-tetramethylpiperidine, 4-(N-i-propyl-N-formylamino)-2,2,6,6-tetramethylpiperidine, 4-(N-i-propyl-N-formylamino)-2,2,6,6-tetramethylpiperidine, 4-(N-t-butyl-N-formylamino)-2,2,6,6-tetramethylpiperidine, 4-(N-isopropylbenzyl-N-formylamino)-2,2,6,6-tetramethylpiperidine, 4-(N-ethoxyethyl-N-formylamino)-2,2,6,6-tetramethylpiperidine, 4-(N-ethoxypropyl-N-formylamino)-2,2,6,6-tetramethylpiperidine, 4-(N-octadecyl-N-formylamino)-2,2,6,6-tetramethylpiperidine, 4-(N-octyl-N-formylamino)-2,2,6,6-tetramethyl-N-methylpiperidine, 4-(N-octyl-N-formylamino)-2,2,6,6-tetramethylpiperidine, 4-(N-chlorobenzyl-N-formylamino)-2,2,6,6-tetramethylpiperidine, 4-(N-diethylaminoethyl-N-formylamino)-2,2,6,6-tetramethylpiperidine, 4-(N-cyclododecyl-N-formylamino)-2,2,6,6-tetramethylpiperidine, 4-(N-cyclohexyl-N-formylamino)-2,2,6,6-tetramethyl-N-methylcarbonylpiperidine, 4-(N-cyclohexyl-N-formylamino)-2,2,6,6-tetramethyl-N-methylpyridine, 4-(N-cyclohexyl-N-formylamino)-2,2,6,6-tetramethylpyridine, 4-(N-cyclopentyl-N-formylamino)-2,2,6,6-tetramethyl-N-methylpiperidine, 4-(N-cyclopentyl-N-formylamino)-2,2,6,6-tetramethylpiperidine, 4-(N-dimethylaminopropyl-N-formylamino)-2,2,6,6-tetramethylpiperidine, 4-(N-decyl-N-formylamino)-2,2,6,6-tetramethyl-N-methylpiperidine, 4-(N-decyl-N-formylamino)-2,2,6,6-tetramethylpiperidine, 4-(N-dodecyl-N-formylamino)-2,2,6,6-tetramethylpiperidine, 4-(N-pyridinylmethyl-N-formylamino)-2,2,6,6-tetramethylpiperidine, 4-(N-phenylethyl-N-formylamino)-2,2,6,6-tetramethyl-N-methylpyridine, 4-(N-phenylethyl-N-formylamino)-2,2,6,6-tetramethylpyridine, 4-(N-butyl-N-formylamino)-2,2,6,6-tetramethyl-N-methylpiperidine, 4-(N-butyl-N-formylamino)-2,2,6,6-tetramethyl-N-methylpiperidine, 4-(N-fluorobenzyl-N-formylamino)-2,2,6,6-tetramethylpiperidine, 4-(N-hexyl-N-formylamino)-2,2,6,6-tetramethyl-N-methylpiperidine, 4-(N-hexyl-N-formylamino)-2,2,6,6-tetramethylpiperidine, 4-(N-pentyl-N-formylamino)-2,2,6,6-tetramethyl-N-methylpiperidine, 4-(N-pentyl-N-formylamino)-2,2,6,6-tetramethylpiperidine, 4-(N-methylcyclohexyl-N-formylamino)-2,2,6,6-tetramethylpyridine, 4-(N-methylbenzyl-N-formylamino)-2,2,6,6-tetramethylpiperidine, 4-(N-methoxybenzyl-N-formylamino)-2,2,6,6-tetramethylpiperidine, 4-(formylamino)-2,2,6,6-tetramethyl-N-methylpiperidine, 4-(formylamino)-2,2,6,6-tetramethylpiperidine, 4-[N-(2,2,6,6-tetramethyl-4-piperidyl)-N-formylamino]-2,2,6,6-tetramethyl-N-methylpyridine, 4-[N-(2,2,6,6-tetramethyl-4-piperidyl)-N-formylamino]-2,2,6,6-tetramethylpyridine, N,N',N",N‴-tetrakis-(4,6-bis(butyl-(N-methyl-2,2,6,6-tetramethylpiperidin-4-yl)amino)-triazine-2-yl)-4,7-diazadecane-1,10-amine, N,N'-bis(2,2,6,6-tetramethyl-4-N-methylpiperidyl)-N,N'-diformyl-1,4-xylylenediamine, N,N'-bis(2,2,6,6-tetramethyl-4-N-methylpiperidyl)-N,N'-diformyl-trimethylenediamine,
N,N'-bis(2,2,6,6-tetramethyl-4-N-methylpiperidyl)-N,N'-diformyl-hexamethylenediamine, N,N'-bis(2,2,6,6-tetramethyl-4-N-methylpiperidyl)-N,N'-diformyl-ethylenediamine, N,N'-bis(2,2,6,6-tetramethyl-4-piperidyl)-N,N'-diformyl-1,4-xylylenediamine, N,N'-bis(2,2,6,6-tetramethyl-4-piperidyl)-N,N'-diformylethylenediamine, N,N'-bis(2,2,6,6-tetramethyl-4-piperidyl)-N,N'-diformyl-trimethylenediamine, N,N'-bis(2,2,6,6-tetramethyl-4-piperidyl)-N,N'-diformylhexamethylenediamine, N,N'-bis(2,2,6,6-tetramethyl-4-piperidyl)-N,N'-bishexamethylene acrylic acid amide, N,N'-bis(2,2,6,6-tetramethyl-4-piperidyl)-N,N'-bishexamethylene arachic acid amide, N,N'-bis(2,2,6,6-tetramethyl-4-piperidyl)-N,N'-bishexamethylene angelic acid amide, N,N'-bis(2,2,6,6-tetramethyl-4-piperidyl)-N,N'-bishexamethylene undecylic acid amide, N,N'-bis(2,2,6,6-tetramethyl-4-piperidyl)-N,N'-bishexamethylene undecylenic acid amide, N,N'-bis(2,2,6,6-tetramethyl-4-piperidyl)-N,N'-bishexamethylene oleic acid amide, N,N'-bis(2,2,6,6-tetramethyl-4-piperidyl)-N,N'-bishexamethylene gadoleic acid amide, N,N'-bis(2,2,6,6-tetramethyl-4-piperidyl)-N,N'-bishexamethylene caprylic acid amide, N,N'-bis(2,2,6,6-tetramethyl-4-piperidyl)-N,N'-bishexamethylene capric acid amide, N,N'-bis(2,2,6,6-tetramethyl-4-piperidyl)-N,N'-bishexamethylene caproic acid amide, N,N'-bis(2,2,6,6-tetramethyl-4-piperidyl)-N,N'-bishexamethylene crotonic acid amide, N,N'-bis(2,2,6,6-tetramethyl-4-piperidyl)-N,N'-bishexamethylene citronellic acid amide, N,N'-bis(2,2,6,6-tetramethyl-4-piperidyl)-N,N'-bishexamethylene stearic acid amide, N,N'-bis(2,2,6,6-tetramethyl-4-piperidyl)-N,N'-bishexamethylene zoomaric acid amide, N,N'-bis(2,2,6,6-tetramethyl-4-piperidyl)-N,N'-bishexamethylene tridecylic acid amide, N,N'-bis(2,2,6,6-tetramethyl-4-piperidyl)-N,N'-bishexamethylene nonadecylic acid amide, N,N'-bis(2,2,6,6-tetramethyl-4-piperidyl)-N,N'-bishexamethylene palmitic acid amide, N,N'-bis(2,2,6,6-tetramethyl-4-piperidyl)-N,N'-bishexamethylene brenzterebic acid amide, N,N'-bis(2,2,6,6-tetramethyl-4-piperidyl)-N,N'-bishexamethylene propionic acid amide, N,N'-bis(2,2,6,6-tetramethyl-4-piperidyl)-N,N'-bishexamethylene heptanoic acid amide, N,N'-bis(2,2,6,6-tetramethyl-4-piperidyl)-N,N'-bishexamethylene behenic acid amide, N,N'-bis(2,2,6,6-tetramethyl-4-piperidyl)-N,N'-bishexamethylene pelargonic acid amide, N,N'-bis(2,2,6,6-tetramethyl-4-piperidyl)-N,N'-bishexamethylene pentadecylic acid amide, N,N'-bis(2,2,6,6-tetramethyl-4-piperidyl)-N,N'-bishexamethylene margaric acid amide, N,N'-bis(2,2,6,6-tetramethyl-4-piperidyl)-N,N'-bishexamethylene myristic acid amide, N,N'-bis(2,2,6,6-tetramethyl-4-piperidyl)-N,N'-bishexamethylene lauric acid amide, N,N'-bis(2,2,6,6-tetramethyl-4-piperidyl)-N,N'-bishexamethylene linderic acid amide, N,N'-bis(2,2,6,6-tetramethyl-4-piperidyl)-N,N'-bishexamethylene valeric acid amide, N,N'-bis(2,2,6,6-tetramethyl-4-piperidyl)-N,N'-bishexamethylene acetic acid amide, N,N'-bis(2,2,6,6-tetramethyl-4-piperidyl)-N,N'-bishexamethylene physeteric acid amide, N,N'-bis(2,2,6,6-tetramethyl-4-piperidyl)-N,N'-bishexamethylene butyric acid amide,
a polymerized product of dimethyl succinate and 4-hydroxy-2,2,6,6-tetramethyl-1-piperidine ethanol, a polycondensate of dibutylamine, 1,3,5-triazine, and N,N'-bis(2,2,6,6-tetramethyl-4-piperidyl)butylamine, bis(1,2,2,6,6-pentamethyl-4-piperidyl)-2-(3,5-di-t-butyl-4-hydroxybenzyl)-2-n-butylmalonate, bis(2,2,6,6-tetramethyl-4-piperidyl)sebacate, poly[(6-morpholino-s-triazine-2,4-diyl)[(2,2,6,6-tetramethyl-4-piperidyl)imino]-hexamethylene[(2,2,6,6-tetramethyl-4-piperidyl)imino], poly[{ (1,1,3,3-tetramethylbutyl)amino-1,3,5-triazine-2,4-diyl}{ (2,2,6,6-tetramethyl-4-piperidyl)imino}hexamethylene{ (2,2,6,6-tetramethyl-4-piperidyl) imino }], poly[{6-(1,1,3,3-tetramethylbutyl)amino-1,3,5-triazine-2,4-diyl}{ (2,2,6,6-tetramethyl-4-piperidyl)imino}hexamethylene{(2,2,6,6-tetramethyl-4-piperidyl)imino}], and a reaction product of a polymer of N,N'-bis(2,2,6,6-tetramethyl-4-piperidinyl)-1,6-hexanediamine and 2,4,6-trichloro-1,3,5-triazine, N-butyl-1-butaneamine, and N-butyl-2,2,6,6-tetramethyl-4-piperidinamine.

Among these, from the viewpoint of obtaining excellent weather resistance, N,N'-bis(2,2,6,6-tetramethyl-4-N-methylpiperidyl)-N,N'-diformyl-alkylenediamines, N,N'-bis(2,2,6,6-tetramethyl-4-piperidyl)-N,N'-diformylalkylenediamines, N,N'-bis(2,2,6,6-tetramethyl-4-piperidyl)-N,N'-bisalkylene fatty acid amides, and poly[{6-(1,1,3,3-tetramethylbutyl)amino-1,3,5-triazine-2,4-diyl}{(2,2,6,6-tetramethyl-4-piperidyl)imino}hexamethylene{(2,2,6,6-tetramethyl-4-piperidyl)imino}] are preferable, and N,N'-bis(2,2,6,6-tetramethyl-4-piperidyl)-N,N'-diformylalkylenediamines, and a reaction product of a polymer of N,N'-bis(2,2,6,6-tetramethyl-4-piperidinyl)-1,6-hexanediamine and 2,4,6-trichloro-1,3,5-triazine, N-butyl-1-butaneamine, and N-butyl-2,2,6,6-tetramethyl-4-piperidinamine are particularly preferable.

The amount of the light stabilizer with respect to 100 parts by weight of the block copolymer hydride is usually 0.01 parts by weight or more, preferably 0.02 parts by weight or more, and more preferably 0.03 parts by weight or more, and is usually 5 parts by weight or less, preferably 2 parts by weight or less, and more preferably 1 part by weight or less. When the amount of the light stabilizer is set to be not smaller than the lower limit of the aforementioned range, weather resistance can be enhanced. When the amount of the light stabilizer is set to be not larger than the upper limit, dirt in a T-die or a cooling roll of an extruder can be prevented during the melt molding process in which the sealing resin composition is molded into a film shape, whereby processability can be enhanced.

Examples of the ultraviolet absorbers may include benzophenone-based ultraviolet absorbers, salicylic acid-based ultraviolet absorbers, and benzotriazole-based ultraviolet absorbers.

Examples of the benzophenone-based ultraviolet absorbers may include 2,4-dihydroxy benzophenone, 2-hydroxy-4-methoxy benzophenone, 2-hydroxy-4-methoxy benzophenone-5-sulfonic acid trihydrate, 2-hydroxy-4-octyloxy benzophenone, 4-dodecaloxy-2-hydroxy benzophenone, 4-benzyloxy-2-hydroxy benzophenone, 2,2',4,4'-tetrahydroxy benzophenone, and 2,2'-dihydroxy-4,4'-dimethoxy benzophenone.

Examples of the salicylic acid-based ultraviolet absorbers may include phenyl salicylate, 4-t-butylphenyl-2-hydroxy benzoate, phenyl-2-hydroxy benzoate, 2,4-di-t-butylphenyl-3,5-di-t-butyl-4-hydroxy benzoate, and hexadecyl-3,5-di-t-butyl-4-hydroxy benzoate.

Examples of the benzotriazole-based ultraviolet absorbers may include 2-(2-hydroxy-5-methylphenyl)-2H-benzotriazole, 2-(3-t-butyl-2-hydroxy-5-methylphenyl)-5-chloro-2H-benzotriazole, 2-(3,5-di-t-butyl-2-hydroxyphenyl)-5-chloro-2H-benzotriazole, 2-(3,5-di-t-butyl-2-hydroxyphenyl)-2H-benzotriazole, 5-chloro-2-(3,5-di-t-butyl-2-hydroxyphenyl)-2H-benzotriazole, 2-(3,5-di-t-amyl-2-hydroxyphenyl)-2H-benzotriazole, 2-(2-hydroxy-5-t-octylphenyl)-2H-benzotriazole, 2-(2-hydroxy-4-octylphenyl)-2H-benzotriazole, 2-(2H-benzotriazole-2-yl)-4-methyl-6-(3,4,5,6-tetrahydrophthalimidylmethyl)phenol, and 2,2'-methylenebis[4-(1,1,3,3-tetramethylbutyl)-6-[(2H-benzotriazole-2-yl)phenol]].

The amount of the ultraviolet absorber with respect to 100 parts by weight of the block copolymer hydride is usually 0.01 parts by weight or more, preferably 0.02 parts by weight or more, and more preferably 0.04 parts by weight or more, and is usually 1 part by weight or less, preferably 0.5 parts by weight or less, and more preferably 0.3 parts by weight or less. When the amount of the ultraviolet absorber to be used is equal to or larger than the lower limit of the aforementioned range, light resistance can be improved. When the ultraviolet absorber is used in excess over the upper limit, further improvement is hardly obtained.

Examples of the antioxidants may include phosphorus-based antioxidants, phenol-based antioxidants and sulfur-based antioxidants. The phosphorus-based antioxidants are preferable because of less noticeable coloration.

Examples of the phosphorus-based antioxidants may include monophosphite-based compounds such as triphenyl phosphite, diphenyl isodecyl phosphite, phenyl diisodecyl phosphite, tris(nonylphenyl)phosphite, tris(dinonylphenyl)phosphite, tris(2,4-di-t-butylphenyl)phosphite, and 10-(3,5-di-t-butyl-4-hydroxybenzyl)-9,10-dihydro-9-oxa-10-phosphaphenanthrene-10-oxide; diphosphite-based compounds such as 4,4'-butylidene-bis(3-methyl-6-t-butylphenyl-di-tridecyl phosphite), and 4,4'-isopropyliden-bis(phenyl-di-alkyl(C12 to C15)phosphite); and compounds such as 6-[3-(3-t-butyl-4-hydroxy-5-methylphenyl)propoxy]-2,4,8,10-tetrakis-t-butyldibenzo[d,f][1.3.2]dioxaphosphepin, and 6-[3-(3,5-di-t-butyl-4-hydroxyphenyl)propoxy]-2,4,8,10-tetrakis-t-butyldibenzo[d,f][1.3.2]dioxaphosphepin.

Examples of the phenol-based antioxidants may include compounds such as pentaerythrityl-tetrakis[3-(3,5-di-t-butyl-4-hydroxyphenyl)propionate], 2,2-thio-diethylenebis[3-(3,5-di-t-butyl-4-hydroxyphenyl)propionate], octadecyl-3-(3,5-di-t-butyl-4-hydroxyphenyl)propionate, 3,9-bis{2-[3-(3-t-butyl-4-hydroxy-5-methylphenyl)propionyloxy]-1,1-dimethylethyl}-2,4,8,10-tetraoxaspiro[5,5]undecane, and 1,3,5-trimethyl-2,4,6-tris(3,5-di-t-butyl-4-hydroxybenzyl)benzene.

Examples of the sulfur-based antioxidants may include compounds such as dilauryl-3,3'-thiodipropionate, dimyristyl 3,3'-thiodipropionate, distearyl-3,3'-thiodipropionate, laurylstearyl-3,3'-thiodipropionate, pentaerythritol-tetrakis-(P-lauryl-thio-propionate), and 3,9-bis(2-dodecylthioethyl)-2,4,8,10-tetraoxaspiro[5,5]undecane.

The amount of the antioxidant with respect to 100 parts by weight of the block copolymer hydride is usually 0.01 parts by weight or more, preferably 0.05 parts by weight or more, and more preferably 0.1 parts by weight or more, and usually 1 part by weight or less, preferably 0.5 parts by weight or less, and more preferably 0.3 parts by weight or less. When the amount of the antioxidant to be used is equal to or larger than the lower limit of the aforementioned range, heat stability can be improved. When the antioxidant is used in excess over the upper limit, further improvement is hardly obtained.

Examples of the method of mixing the block copolymer hydride and the optional components may include a method of dissolving the optional components in an appropriate solvent, mixing it with a solution of the block copolymer hydride, and then removing the solvent to obtain the sealing resin composition containing the optional components; and a method of kneading the block copolymer hydride in a molten state with the optional components using a biaxial kneader, a roll, a Brabender, an extruder, etc.

The sealing resin composition does not necessarily have high transparency. However, when the sealing resin composition is used as a material for an optical member, it is preferable that the sealing resin composition has high transparency. For example, the total light transmittance measured with a sample of the sealing resin composition having a thickness of 1 mm is usually 70% or more, preferably 80% or more, and more preferably 90% or more. The upper limit of the total light transmittance may be set to 100% or less.

### [4. Film of Sealing Resin Composition]

The sealing resin composition used according to the present invention may be molded into a film shape prior to use. The thickness of the film is preferably 10 µm or more, more preferably 20 µm or more, and particularly preferably 40 µm or more, and is preferably 500 µm or less, more preferably 200 µm or less, and particularly preferably 100 µm or less. When the thickness of the film is set to be not less than the lower limit of the aforementioned range, the film can be manufactured by extrusion molding. Further, by having such a degree of thickness, the film can have a sufficient sealing function, and unevenness in the thickness of the film due to small foreign substances can be prevented even when the film is contaminated with such small foreign substances. When the thickness is set to be not more than the upper limit, deflection after the lamination can be suppressed, to thereby enable uniform film formation, and a thin device can be obtained.

The film of the sealing resin composition is usually prepared as a long-length film, and an organic electronic device is manufactured with this film. The method for producing the film is not particularly limited. Examples thereof may include a melt molding method and a solution casting method. The melt molding method is further classified into an extrusion molding method, e.g., a press molding method, an inflation molding method, an injection molding method, a blow molding method, a stretch molding method, etc. Among these, an extrusion molding method, an inflation molding method, or a press molding method is preferable for obtaining a film that has excellent mechanical strength, surface accuracy, etc. Furthermore, an extrusion molding method is particularly preferable, because thereby a film can be efficiently and easily manufactured.

### [5. Organic Electronic device]

The organic electronic device according to claim 8 of the present invention includes a layer of the organic electronic device sealing resin composition used according to claim 1 of the present invention.

The organic electronic device according to the present invention may include an element such as an organic EL element and an organic semiconductor element as an element that expresses the function of the device. The organic electronic device according to the present invention may also include a substrate having a sealing function, and may have a structure in which the element is sealed by the substrate and the layer of the sealing resin composition.

A specific example of the organic electronic device including an organic EL element as an element will be described with reference to the drawings.

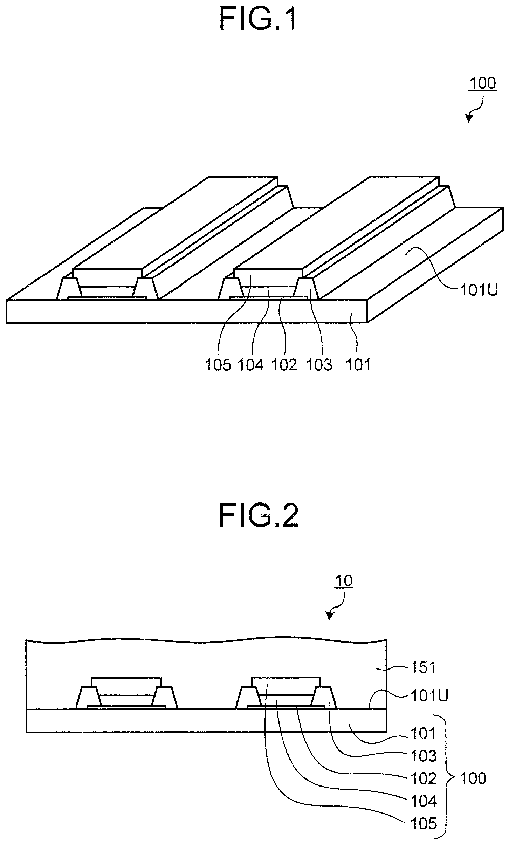

Fig. 1 is a perspective view schematically illustrating an assembly constituting an organic electronic device that contains components such as an organic EL element. Fig. 2 is a vertical sectional view schematically illustrating an example of an organic electronic device that includes the assembly and a layer of a sealing resin composition.

In Fig. 1, an assembly 100 includes a substrate 101, a number of first electrode layers 102 each formed in an elongated band shape on a top surface 101U of the substrate 101, an edge cover layer 103 formed on the periphery of each of the first electrode layers 102, a light-emitting layer 104 disposed on the first electrode layer 102, and a second electrode layer 105 disposed on the light-emitting layer 104.

The first electrode layer 102, the light-emitting layer 104, and the second electrode layer 105 constitute a light-emitting element, and the application of electric current to the first and second electrode layers can cause light emission from the light-emitting layer.

The material, thickness, and method for producing the elements constituting the assembly 100 are not particularly limited, and any known ones may be adopted. Examples of the material of the substrate may include a flexible substrate composed of flexible transparent plastics such as polycarbonate, polyethylene terephthalate, polyethylene naphthalate, and alicyclic olefin polymers; and a glass substrate of, e.g., quartz, soda glass, and inorganic alkali glass.

The light-emitting layer is not particularly limited, and any known light-emitting layer may be appropriately selected. In conformity with its use as a light source, a layer that can emit a light containing a desired peak wavelength may be configured by one type of layer or a combination of two or more types of layers.

The material constituting the first and second electrode layers is not particularly limited, and any known material used as an electrode of an organic EL element may be appropriately selected. One of the electrode layers may be configured to serve as a positive electrode, whereas the other may be configured to serve as a negative electrode. When one of the first electrode layer and the second electrode layer is configured as a transparent electrode whereas the other is configured as a reflection electrode, light emission from the transparent electrode side can be achieved. Alternatively, both the first electrode layer and the second electrode layer may be configured as transparent electrodes. Examples of the material of the transparent electrode may include a metal thin film, ITO, IZO and SnO₂. Examples of the material of the reflection electrode may include aluminum and MgAg.

In addition to the light-emitting layer, the element may further have an optional layer between the first electrode layer and the second electrode layer, such as a hole injection layer, a hole transport layer, an electron transport layer, an electron injection layer, and a gas barrier layer. These optional layers may also serve as constituents of the light-emitting element.

Examples of a specific layer structure of the light-emitting element may include a structure of positive electrode / hole transport layer / light-emitting layer / negative electrode, a structure of positive electrode / hole transport layer / light-emitting layer / electron injection layer / negative electrode, a structure of positive electrode / hole injection layer / light-emitting layer / negative electrode, a structure of positive electrode / hole injection layer / hole transport layer / light-emitting layer / electron transport layer / electron injection layer / negative electrode, a structure of positive electrode / hole transport layer / light-emitting layer / electron injection layer / equipotential surface formation layer / hole transport layer / light-emitting layer / electron injection layer / negative electrode, and a structure of positive electrode / hole transport layer / light-emitting layer / electron injection layer / electric charge generating layer / hole transport layer / light-emitting layer / electron injection layer / negative electrode. While the light-emitting element in the device according to the present invention may include one or more light-emitting layers between the positive electrode and the negative electrode, the light-emitting element may include, as the light-emitting layer, a layered body containing a plurality of layers having different light-emitting colors, or a mixed layer that is a layer having a certain pigment doped with a different pigment. Examples of the material constituting the light-emitting layer may include polyparaphenylene vinylene-based, polyfluorenebased, and polyvinylcarbazole-based materials. Examples of the material of the hole injection layer and the hole transport layer may include phthalocyanine-based, arylamine-based, and polythiophen-based materials. Examples of the material of the electron injection layer and the electron transport layer may include aluminum complexes and lithium fluoride. Examples of the material of the equipotential surface formation layer and the electric charge generating layer may include a transparent electrode such as ITO, IZO, and SnO₂, as well as a metal thin layer of, e.g., Ag and Al.

The first electrode layer, the light-emitting layer, the second electrode layer, and other optional layers each constituting the light-emitting element may be disposed by sequentially laminating these layers on a substrate. The thickness of each of these layers may be 10 to 1000 nm.

The assembly 100 may further include other optional components such as wiring for applying electric current to the electrode layers.

In Fig. 2, an organic electronic device 10 includes a sealing resin composition layer 151 disposed on the top surface 101U side of the assembly 100. By having such a structure, the light-emitting layer 104 is sealed by the substrate 101 and the sealing resin composition layer 151. Furthermore, since the sealing resin composition layer 151 is constituted by the sealing resin composition according to the present invention, degassing is reduced. As a result, favorable sealing is achieved, and properties such as the life of the device is enhanced. Furthermore, the deformation ability of the sealing resin composition enables covering of unevenness on the assembly 100, whereby the strength of the device can be enhanced.

Examples of the method for disposing the sealing resin composition layer 151 on the assembly 100 may include the aforementioned method of pressure-bonding the film of the sealing resin composition. Examples of the pressure-bonding may include a method of increasing the temperature of the film to approximately 100 to 150°C, and bonding the film using a vacuum laminating apparatus.

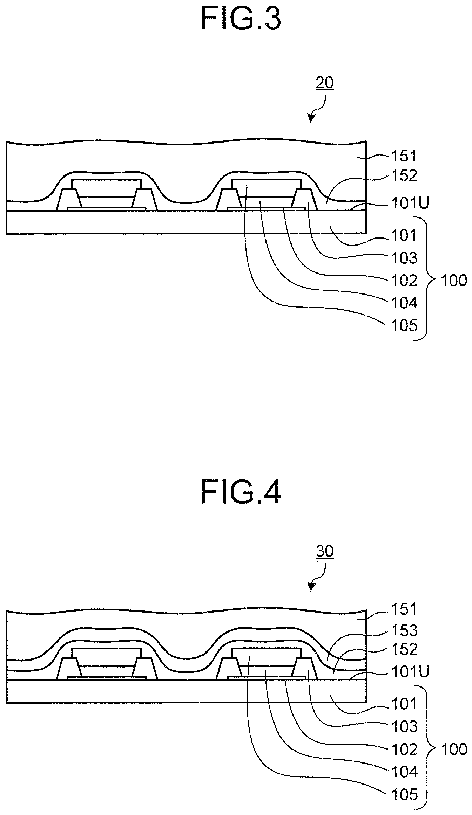

Fig. 3 is a vertical sectional view schematically illustrating another example of the organic electronic device according to the present invention.

In Fig. 3, an organic electronic device 20 includes the assembly 100, a temporary sealing layer 152 disposed on the top surface 101U side of the assembly 100, and the sealing resin composition layer 151 disposed on the temporary sealing layer 152.

Examples of the material of the temporary sealing layer 152 may include a material containing silicon such as SiN and SiO. The thickness of the temporary sealing layer 152 may be approximately 0.2 to 1 µm.

The temporary sealing layer 152 may be formed by a film formation method such as vapor deposition under the conditions of reduced pressure similar to those for the light-emitting layer 104 and the second electrode layer 105. Therefore, the light-emitting layer 104, the second electrode layer 105, and the temporary sealing layer 152 may be continuously disposed under a reduced pressure environment, to thereby effectively suppress deterioration of the light-emitting layer. After taking the layers out of the reduced pressure environment, sealing with the sealing resin composition layer 151 may be performed, to thereby form a firm sealing that is capable of tolerating the device usage environment. Accordingly, a device in which deterioration of elements during manufacture is reduced, and such a state is maintained for a long period of time even under the usage environment can be obtained.

Fig. 4 is a vertical sectional view schematically illustrating still another example of the organic electronic device according to the present invention.

In Fig. 4, an organic electronic device 30 includes the assembly 100, the temporary sealing layer 152 disposed on the top surface 101U side of the assembly 100, an absorbent layer 153 disposed on the temporary sealing layer 152, and the sealing resin composition layer 151 disposed on the absorbent layer 153.

Examples of the material of the absorbent layer 153 may include an organic aluminum complex. The thickness of the absorbent layer 153 may be approximately 0.1 to 1 µm. By disposing the absorbent layer 153, still further rigid sealing can be obtained. For example, the absorbent layer 153 can absorb a gas component that may be slightly emitted from the sealing resin composition layer 151, to thereby achieve further prevention of deterioration of the layers such as the light-emitting layer 104.

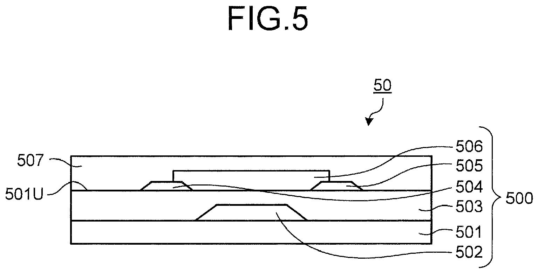

A specific example of the organic electronic device including an organic semiconductor as an element will be described with reference to the drawing. Fig. 5 is a vertical sectional view schematically illustrating still another example of the organic electronic device according to the present invention containing components such as an organic semiconductor.

In Fig. 5, an organic electronic device 50 includes an assembly 500, and a sealing resin composition layer 507 disposed on a top surface of the assembly 500. The assembly 500 includes a substrate 501, a gate electrode 502 disposed on a top surface of the substrate 501 and a gate electrode insulating layer 503 disposed on top surfaces of the substrate 501 and the gate electrode 502, and a semiconductor layer 506, a source electrode 504 and a drain electrode 505 disposed on a top surface of the gate electrode insulating layer 503.

The material, thickness, and method for producing the organic electronic device 50 are not particularly limited, and any known ones may be adopted.

Examples of the material of the substrate 501 are not limited to particular ones, and may include a flexible substrate composed of flexible plastics such as polycarbonate, polyimide, polyethylene terephthalate, polyethylene naphthalate, and alicyclic olefin polymers, a glass substrate of, e.g., quartz, soda glass, and inorganic alkali glass, and a silicon substrate such as a silicon wafer.

The gate electrode 502 may be formed from a conductive material. Examples of the conductive material may include platinum, gold, silver, nickel, chromium, copper, iron, tin, antimonial lead, tantalum, indium, palladium, tellurium, rhenium, iridium, aluminum, ruthenium, germanium, molybdenum, tungsten, tin antimony oxide, indium tin oxide (ITO), fluorine-doped zinc oxide, zinc, carbon, graphite, glassy carbon, silver paste and carbon paste, lithium, beryllium, magnesium, potassium, calcium, scandium, titanium, manganese, zirconium, gallium, niobium, sodium, sodium-potassium alloy, magnesium/copper mixture, magnesium/silver mixture, magnesium/aluminum mixture, magnesium/indium mixture, aluminum/aluminum oxide mixture, and lithium/aluminum mixture. Further examples thereof may include publicly known conductive polymers having an improved conductivity by, e.g., doping, such as conductive polyaniline, conductive polypyrrole and conductive polythiophen (for example, complexes of polyethylenedioxythiophen and polystyrene sulfonic acid). Among these, chromium and molybdenum are preferable, and chromium is more preferable. The gate electrode 502 may be formed in a predetermined pattern on the substrate 501, by, e.g., forming the aforementioned conductive material on the substrate 501 by, e.g., sputtering, and subsequently performing etching treatment.

It is preferable that the material of the gate insulating film 503 has sealing property, moisture resistance, insulation property, and chemical resistance. Specific examples thereof may include thermoplastic resins such as polyimide, polyester, polyethylene naphthalate, polycarbonate, polyethylene, polyethylene terephthalate, and polyether sulfone. Alternatively, the same resins as those for the sealing resin composition layer 507 may be used.

The semiconductor layer 506 may be formed from an organic semiconductor. Examples of the organic semiconductor may include, as a p-channel type, lowmolecular semiconductors such as pentacene, naphthacene, thiophene oligomer, perylene, α-sexiphenyl and derivatives thereof, naphthalene, anthracene, rubrene and derivatives thereof, coronene and derivatives thereof, and metalcontaining or -not containing phthalocyanine and derivatives thereof; and polymer semiconductors such as polyalkylthiophen and polyalkylfluorene based on thiophen and fluorene, and derivatives thereof. The semiconductor layer 506 is formed by, e.g., forming the aforementioned organic semiconductor on the gate insulating film 503 by, e.g., a coating or CVD method, and subsequently patterning the formed semiconductor into a predetermined pattern shape.

The source electrode 504 and the drain electrode 505 may be formed from a conductive material. Examples of the conductive material may include the same materials as those for the aforementioned gate electrode 502. The source electrode 504 and the drain electrode 505 may be formed on the semiconductor layer 506 in a predetermined pattern by, e.g., forming the aforementioned conductive material on the semiconductor layer 506 by, e.g., a sputtering method, and subsequently performing etching treatment.

In Fig. 5, the organic electronic device as an organic semiconductor includes the sealing resin composition layer 507 disposed on a top surface 501U side of the assembly 500. By having such a structure, the semiconductor layer 506, the source electrode 504, and the drain electrode 505 are sealed by the gate electrode insulating layer 503 and the sealing resin composition layer 507. Furthermore, since the sealing resin composition layer 507 is composed of the sealing resin composition according to the present invention, degassing is reduced. As a result, favorable sealing is achieved, and properties such as the life of the device is enhanced. Furthermore, the deformation ability of the sealing resin composition enables covering of unevenness on the assembly 500, whereby the strength of the device can be enhanced.

### Examples

The present invention will be specifically described hereinbelow by referring to Examples. However, the present invention is not limited to the following Examples.

Unless otherwise stated, "%" and "part" indicating quantity in the following description are based on weight.

### [Preparative Example 1: Assembly Including White Organic EL element]

An assembly with a temporary sealing layer, including a white organic EL element, was prepared. The structure of the assembly with a temporary sealing layer was schematically as that of the assembly 100 and the temporary sealing layer 152 illustrated in Fig. 3. However, the assembly with a temporary sealing layer included not only a single light-emitting layer, but also a hole transport layer, a plurality of light-emitting layers, an electron transport layer and a buffer layer between the first electrode and the second electrode.

A layer of ITO was formed on the light transmissive glass substrate 101 by deposition (under a reduced pressure of 10⁻⁴ Pa). This layer of ITO was patterned into a strip-like shape having a thickness of 0.25 µm, a width of 500 µm and a length of 10 mm by photolithography, to form a transparent positive electrode as the first electrode layer 102.

Subsequently, application of a photoresist (ZWD6216 manufactured by ZEON Corporation) and photolithography were performed, to thereby form an edge cover layer 103 having a thickness of 1.0 µm on the periphery of the positive electrode.

Subsequently, NPB (4,4'-bis[N-(1-naphthyl)-N-phenylamino]biphenyl) was deposited on the positive electrode, to thereby form a hole transport layer having a thickness of 40 nm.

Subsequently, ADS082 (4,4-bis(diphenylvinylene)-biphenyl) as a blue light-emitting material was deposited on the hole transport layer, to thereby form a blue light-emitting layer having a thickness of 0.05 µm.

Subsequently, DCJTB (4-(dicyanomethylene)-2-t-butyl-6-(1,1,7,7-tetramethyljulolidil-9-enyl)-4H-pyran) as a red light-emitting material was deposited on the blue light-emitting layer, to thereby form a red light-emitting layer having a thickness of 0.05 µm.

Subsequently, Alq₃ (tris(8-hydroxyquinolinato)aluminum) was deposited on the red light-emitting layer, to thereby form a green light-emitting layer having a thickness of 0.05 µm and an electron transport layer.

Subsequently, LiF was deposited on the electron transport layer, to thereby form a buffer layer having a thickness of 0.5 nm.

Subsequently, aluminum was deposited on the buffer layer, to thereby form a negative electrode (reflection electrode) having a thickness of 50 nm as the second electrode layer 105.

Then, SiN was deposited so as to cover the entire surface of the formed layers and substrate, to thereby form a temporary sealing layer 152 having a thickness of 0.3 µm.

The depositions of the hole transport layer through the temporary sealing layer were continuously performed while maintaining the condition of a pressure of 10⁻⁴ to 10⁻⁶ Pa.

By the aforementioned operations, an assembly with a temporary sealing layer was prepared.

### [Preparative Example 2: Sealing Resin Composition Film 1]

A block copolymer having a triblock structure in which polymer blocks [A] are bonded to both ends of a polymer block [B] was produced by the following procedure using styrene as an aromatic vinyl compound and isoprene as a linear conjugated diene compound.

Into a reaction vessel equipped with a stirrer, inside which the atmosphere had been sufficiently replaced with nitrogen, 256 parts of dehydrated cyclohexane, 25.0 parts of dehydrated styrene, and 0.615 parts of di-n-butyl ether were placed. Then, 1.35 parts of n-butyl lithium (a 15% cyclohexane solution) was added to this mixture while stirring at 60°C to initiate polymerization. Furthermore, the reaction was performed for 60 minutes while stirring at 60°C. The polymerization conversion ratio at this time was 99.5% (measured by gas chromatography, the same applies in the following).

Subsequently, 50.0 parts of dehydrated isoprene was added, and the stirring was continued at the same temperature for 30 minutes. The polymerization conversion ratio at this time was 99%.

Thereafter, 25.0 parts of dehydrated styrene was further added, and stirring was performed at the same temperature for 60 minutes. The polymerization conversion ratio at this time was almost 100%. Subsequently, 0.5 parts of isopropyl alcohol was added to the reaction solution to terminate the reaction. Thus, a solution (i) containing a block copolymer was obtained.

The weight average molecular weight (Mw) of the block copolymer in the obtained solution (i) was 44,900, and the molecular weight distribution (Mw/Mn) was 1.03.

Subsequently, the solution (i) was transferred into a pressure-resistant reaction vessel equipped with a stirrer, and 4.0 parts of a silica-alumina supported type nickel catalyst (E22U, nickel support amount: 60%, manufactured by JGC Chemical Industry Company) as a hydrogenation catalyst and 350 parts of dehydrated cyclohexane were added and mixed. The atmosphere in the reaction vessel was replaced with hydrogen gas, and hydrogen was further supplied while stirring the solution to perform a hydrogenation reaction at a temperature of 170°C and under a pressure of 4.5 MPa for 6 hours. The block copolymer was thereby hydrogenated to obtain a solution (ii) containing a block copolymer hydride (ii). The weight average molecular weight (Mw) of the block copolymer hydride in the solution (ii) was 45,100, and the molecular weight distribution (Mw/Mn) was 1.04.

After termination of the hydrogenation reaction, the solution (ii) was filtered to remove the hydrogenation catalyst. Thereafter, 1.0 part of a xylene solution, in which 0.1 part of 6-[3-(3-t-butyl-4-hydroxy-5-methylphenyl)propoxy]-2,4,8,10-tetrakis-t-butyldibenzo[d,f][1.3.2]dioxaphosphepin (Sumilizer (registered trademark) GP manufactured by Sumitomo Chemical Company, Limited, referred to hereinbelow as an "antioxidant A")) as a phosphorus-based antioxidant had been dissolved, was added and dissolved. Thus, a solution (iii) was obtained.

Subsequently, the solution (iii) was filtered through a Zeta-plus (registered trademark) filter 30H (manufactured by CUNO, pore size: 0.5 to 1 µm), and further filtered through another metal fiber filter (pore size: 0.4 µm, manufactured by Nichidai Co., Ltd.) sequentially to remove a minute solid content. Thereafter, cyclohexane and xylene, which were used as a solvent, and other volatile components, were removed from the solution at a temperature of 260°C and under a pressure of 0.001 MPa or less, using a cylindrical concentration dryer (product name: "Kontro", manufactured by Hitachi, Ltd.). The residue was extruded in a molten state into a strand shape through a die directly connected to the concentration dryer. The extruded product was cooled and then cut by a pelletizer to obtain 85 parts of pellets (iv) of the sealing resin composition containing the block copolymer hydride and the antioxidant A. The weight average molecular weight (Mw) of the block copolymer hydride in the obtained pellets (iv) was 45,000, and the molecular weight distribution (Mw/Mn) was 1.08. The hydrogenation ratio was 99.9%.

The pellets (iv) were uniaxially extrusion-molded at a barrel temperature of 200°C, to thereby obtain a sealing resin composition film 1 having a thickness of 50 µm.

### [Preparative Example 3: Sealing Resin Composition Film 2]

To 100 parts of the pellets (iv) obtained in Preparative Example 2, 2.0 parts of vinyltrimethoxysilane and 0.2 parts of di-t-butyl peroxide were added to obtain a mixture. This mixture was kneaded and extruded using a biaxial extruder at a barrel temperature of 210°C and a retention time of 80 to 90 seconds, and thereafter a pelletizer was used to obtain pellets (v). The pellets (v) were uniaxially extrusion-molded at a barrel temperature of 200°C, to thereby obtain a sealing resin composition film 2 having a thickness of 50 µm.

### [Preparative Example 4: Sealing Resin Composition Film 3]

Into a reaction vessel equipped with a stirrer, inside which the atmosphere had been sufficiently replaced with nitrogen, 550 parts of dehydrated cyclohexane, 25.0 parts of dehydrated styrene, and 0.59 parts of di-n-butyl ether were placed. Then, 1.14 parts of n-butyl lithium (a 15% cyclohexane solution) was added to this mixture while stirring at 60°C to initiate polymerization. Furthermore, the reaction was performed for 60 minutes while stirring at 60°C. The obtained reaction mixture was analyzed by gas chromatography. The polymerization conversion ratio at this time was 99.5% (measured by gas chromatography, the same applies in the following).

Subsequently, 50.0 parts of dehydrated isoprene was added, and the stirring was continued for 30 minutes while keeping that state. The polymerization conversion ratio at this time was 99.5%.

Thereafter, 25.0 parts of dehydrated styrene was further added, and stirred for 60 minutes. The polymerization conversion ratio at this time was almost 100%. Subsequently, 0.5 parts of isopropyl alcohol was added to the reaction solution to terminate the reaction. Thus, a solution (vi) containing a block copolymer was obtained. The weight average molecular weight (Mw) of the obtained block copolymer was 47,000, the molecular weight distribution (Mw/Mn) was 1.03, and wA:wB was 50:50.

Subsequently, the solution (vi) was transferred into a pressure-resistant reaction vessel equipped with a stirrer, and 3.0 parts of a diatomite supported type nickel catalyst (product name "T-8400RL" manufactured by Sudchemie Catalysts Japan Inc.) as a hydrogenation catalyst and 100 parts of dehydrated cyclohexane were added and mixed. The atmosphere in the reaction vessel was replaced with hydrogen gas, and hydrogen was further supplied while stirring the solution to perform a hydrogenation reaction at a temperature of 190°C and under a pressure of 4.5 MPa for 6 hours. The block copolymer was thereby hydrogenated to obtain a solution (vii) containing a block copolymer hydride (vii). The weight average molecular weight (Mw) of the block copolymer hydride (vii) in the solution (vii) was 48,000, and the molecular weight distribution (Mw/Mn) was 1.04.

After termination of the hydrogenation reaction, the solution (vii) was filtered to remove the hydrogenation catalyst. Thereafter, 1.0 part of a xylene solution, in which 0.1 parts of pentaerythrityl tetrakis[3-(3,5-di-t-butyl-4-hydroxyphenylpropionate) (product name "Songnox1010" manufactured by SONGWON) as a phenol-based antioxidant had been dissolved, was added and dissolved. Thus, a solution (viii) was obtained.

Subsequently, the solution (viii) was filtered through a metal fiber filter (pore size: 0.4 µm, manufactured by Nichidai Co., Ltd.) to remove a minute solid content. Thereafter, cyclohexane and xylene, which were used as a solvent, and other volatile components, were removed from the solution at a temperature of 260°C and under a pressure of 0.001 MPa or less, using a cylindrical concentration dryer (product name "Kontro" manufactured by Hitachi, Ltd.) to produce a molten polymer. The polymer was continuously filtrated at a temperature of 260°C through a polymer filter (manufactured by Fuji Filter Mfg Co., Ltd.) with a stainless-made sintered filter having a pore size of 5 µm and connected to a concentration dryer, and the molten polymer was extruded into a strand shape through a die. The extruded product was cooled and then cut by a pelletizer to obtain 96 parts of pellets of the block copolymer hydride (ix). The weight average molecular weight (Mw) of the obtained block copolymer hydride (ix) was 48,000, and the molecular weight distribution (Mw/Mn) was 1.04. The hydrogenation ratio was almost 100%.

To 100 parts of pellets of the obtained block copolymer hydride (ix), 2.0 parts of vinyltrimethoxysilane and 0.2 parts of 2,5-dimethyl-2,5-di(t-butyl peroxy)hexane (product name "Perhexa (registered trademark) 25B" manufactured by NOF Corporation) were added to obtain a mixture. The mixture was kneaded and extruded into a strand shape using a biaxial extruder (product name "TEM37B" manufactured by Toshiba Machine Co. Ltd.) at a resin temperature of 200°C and a retention time of 60 to 70 seconds, and then air-cooled. Thereafter, the extruded product was cut by a pelletizer to obtain 97 parts of pellets of the denatured block copolymer hydride (x) having an alkoxysilyl group.

After 10 parts of the obtained pellets of the denatured block copolymer hydride (x) were dissolved in 100 parts of cyclohexane, the resultant solution was poured into 400 parts of dehydrated methanol to coagulate the denatured block copolymer hydride (x). The coagulated product was filtered off, and then vacuum-dried at 25°C to isolate 9.5 parts of crumbs of the denatured block copolymer hydride (x). For this isolated product, FT-IR spectrum and ¹H-NMR spectrum were observed. In the FT-IR spectrum, a new absorption band attributed to an Si-OCH₃ group was observed at 1090 cm⁻¹, and new absorption bands attributed to an Si-CH₂ group were observed at 825 cm⁻¹ and 739 cm⁻¹. The positions of these absorption bands are different from the positions at 1075 cm⁻¹, 808 cm⁻¹ and 766 cm⁻¹ which are the positions of the absorption band for vinyltrimethoxysilane. Further, in the ¹H-NMR spectrum (in deuterated chloroform), an absorption band based on the protons of a methoxy group was observed at 3.6 ppm. From the peak area ratios in these spectra, it was confirmed that 1.7 parts of vinyltrimethoxysilane were bonded to 100 parts of the block copolymer hydride (ix).

To 100 parts by weight of pellets of the denatured block copolymer hydride (x), 0.5 parts of 2-hydroxy-4-n-octoxy benzophenone as an ultraviolet absorber were added to obtain a mixture. The mixture was extruded at a resin temperature of 190°C, using a biaxial extruder (product name "TEM37BS" manufactured by Toshiba Machine Co. Ltd.) equipped with a side feeder capable of adding a liquid material.

Separately, polyisobutene (product name "Nisseki polybutene LV-100," number average molecular weight: 500, manufactured by JX Nippon Oil & Energy Corporation) as a plasticizer was continuously added from the side feeder in a ratio of 10 parts by weight with respect to 100 parts by weight of the denatured block copolymer hydride (x), and the mixture was extruded into a strand shape. The extruded product was air-cooled, and then cut by a pelletizer to obtain 102 parts of pellets (xi) containing the denatured block copolymer hydride (x) and polyisobutene.

The pellets (xi) were uniaxially extrusion-molded at a barrel temperature of 200°C, to thereby obtain a sealing resin composition film 3 having a thickness of 100 µm.

### [Example 1]

The sealing resin composition film 2 having a thickness of 50 µm obtained in Preparative Example 3 was pressure-bonded at 150°C on the surface of the temporary sealing layer side of the assembly with the temporary sealing layer obtained in Preparative Example 1, to thereby heat-seal the light-emitting element. As a result, there was obtained an organic EL device having a structure schematically illustrated in Fig. 3, including the assembly 100, the temporary sealing layer 152 and the sealing resin composition layer 151.

Electric current was applied to the obtained organic EL device, and it was confirmed that the EL device emits light without any problem. Thereafter, the organic EL device in a lit-off state was subjected to heat treatment at 85°C for a specific time (300 hours or 1000 hours), and thereafter returned to room temperature. Then, electric current was again applied for lighting. The dark spot on the light-emitting surface was observed, and evaluated in accordance with the following evaluation criteria. The results are shown in Table 1.
A: No dark spots, or if any, less than 50 µm in diameter.
B: Few (less than 10 spots/cm²) dark spots having a diameter of not less than 50 µm and less than 200 µm.
C: Many (not less than 10 spots/cm²) dark spots having a diameter of not less than 50 µm and less than 200 µm.
D: Presence of a dark spot having a diameter of not less than 200 µm.

### [Example 2]

An absorbent compound (OleDry-F manufactured by Futaba Corporation) was applied onto the surface of the temporary sealing layer side of the assembly with the temporary sealing layer obtained in Preparative Example 1, and baked at 100°C. Thus, an absorbent layer having a thickness of 0.5 µm was formed. On the obtained absorbent layer, the sealing resin composition film 2 having a thickness 50 µm obtained in Preparative Example 3 was pressure-bonded at 150°C, to thereby heat-seal the light-emitting element. Thus, an organic EL device having the structure illustrated in Fig. 4 was obtained.

Electric current was applied to the obtained organic EL device, and it was confirmed that the EL device emits light without any problem. Thereafter, the organic EL device in a lit-off state was subjected to heat treatment at 85°C for a specific time (300 hours or 1000 hours), and thereafter returned to room temperature. Then, electric current was again applied for lighting, and evaluation was performed in the same manner as in Example 1. The results are shown in Table 1.

### [Example 3]

An organic EL device was obtained and evaluated in the same manner as in Example 2 except that the sealing resin composition film 1 having a thickness of 50 µm obtained in Preparative Example 2 was used in place of the sealing resin composition film 2 having a thickness of 50 µm obtained in Preparative Example 3 in Example 2. The results are shown in Table 1.

### [Example 4]

An organic EL device was obtained and evaluated in the same manner as in Example 2 except that the sealing resin composition film 3 having a thickness of 100 µm obtained in Preparative Example 4 was used in place of the sealing resin composition film 2 having a thickness of 50 µm obtained in Preparative Example 3 in Example 2 and that the pressure-bonding temperature was changed to 100°C. The results are shown in Table 1. The obtained organic EL device did not have a large dark spot attributed to the use of a hot-melt type sealing resin composition film, and was therefore a high-quality device.

### [Comparative Example 1]

SEBS (Tuftec H1051 manufactured by Asahi Kasei Chemicals Corporation, hydrogenation ratio: 60.5%) was uniaxially extruded at a barrel temperature of 210°C, to obtain a film having a thickness of 50 µm. The film was pressure-bonded at 150°C to the surface of the temporary sealing layer side of the assembly with the temporary sealing layer obtained in Preparative Example 1, to thereby heat-seal the light-emitting element. As a result, there was obtained an organic EL device having a structure illustrated in Fig. 3, including the assembly 100, the temporary sealing layer 152, and the sealing resin composition layer 151.

Electric current was applied to the obtained organic EL device, and it was confirmed that the EL device emits light without any problem. Thereafter, the organic EL device in a lit-off state was subjected to heat treatment at 85°C for a specific time (300 hours or 1000 hours), and thereafter returned to room temperature. Then, electric current was again applied for lighting, and evaluation was performed in the same manner as in Example 1. The results are shown in Table 1.

### [Comparative Example 2]

A solution of the same absorbent compound as that used in Example 2 was applied onto the surface of the temporary sealing layer side of the assembly with the temporary sealing layer obtained in Preparative Example 1, and baked. Thereafter, the solvent was volatilized to form an absorbent layer having a thickness of 0.5 µm. On the formed absorbent layer, the same SEES film as that used in Comparative Example 1 was pressure-bonded at 150°C, to thereby heat-seal the light-emitting element. Thus, an organic EL device having the structure illustrated in Fig. 4 was obtained.

Electric current was applied to the obtained organic EL device, and it was confirmed that the EL device emits light without any problem. Thereafter, the organic EL device in a lit-off state was subjected to heat treatment at 85°C for a specific time (300 hours or 1000 hours), and thereafter returned to room temperature. Then, electric current was again applied for lighting, and evaluation was performed in the same manner as in Example 1. The results are shown in Table 1.

### [Table 1]

**Table 1**

| Time | 300 hours | 1000 hours |
|---|---|---|
| Example 1 | A | B |
| Example 2 | A | A |
| Example 3 | A | B |
| Example 4 | A | A |
| Comparative Example 1 | C | D |
| Comparative Example 2 | B | C |

As obvious from the results shown in Table 1, sealing performance was more favorable in Examples, in which the sealing resin composition film satisfying the requirements defined in the present application was used, than in Comparative Examples.

Further, in Example 4, there was used a sealing resin composition film (manufactured in Preparative Example 4) that contains a large amount of a plasticizer and that can be used in a hot-melt scheme. Usually, when such a hot-melt type sealing resin composition film is used as a component of an organic EL device, the organic EL device may be subjected to delamination in an interface between the organic light-emitting layer material and the electrode material layer, and in an interface between the electrode material layer and the substrate layer. Such delamination causes generation of a large dark spot. However, in Example 4, the organic EL device not having such a dark spot was successfully prepared.

### Description of Numerals:

10: Organic electronic device
20: Organic electronic device
30: Organic electronic device
50: Organic electronic device
100: Assembly
101: Substrate
101U: Top surface of substrate
102: First electrode layer
103: Edge cover layer
104: Light-emitting layer
105: Second electrode layer
151: Sealing resin composition layer
152: Temporary sealing layer
153: Absorbent layer
500: Assembly
501: Substrate
501U: Top surface of assembly
502: Gate electrode
503: Gate electrode insulating layer
504: Source electrode
505: Drain electrode
506: Semiconductor layer
507: Sealing resin composition layer

## Claims

1. Use of resin composition comprising a block copolymer hydride obtained by hydrogenating 90% or more of all unsaturated bonds of a block copolymer and a plasticizer at 1 to 50 parts by weight with respect to 100 parts by weight of the block copolymer hydride,
wherein the block copolymer includes:
two or more polymer blocks [A] per one molecule of the copolymer, the block having an aromatic vinyl compound unit as a main component; and
one or more polymer blocks [B] per one molecule of the copolymer, the block having a linear conjugated diene compound unit as a main component, and
a ratio between a weight fraction wA of all the polymer blocks [A] in the entire block copolymer and a weight fraction wB of all the polymer blocks [B] in the entire block copolymer (wA:wB) is 20:80 to 60:40, and
wherein the plasticizer is a hydrocarbon polymer having a number average molecular weight of 200 to 5000,
for sealing an organic electronic device.

2. The use according to claim 1, wherein a weight average molecular weight of the block copolymer hydride is 30,000 to 200,000.

3. The use according to claim 1 or 2, wherein the block copolymer is a triblock copolymer in which the polymer blocks [A] are bonded to both ends of the polymer block [B].

4. The use according to any one of claims 1 to 3, wherein the block copolymer hydride has an alkoxysilyl group.

5. The use according to any one of claims 1 to 4, wherein the polymer block [A] contains the aromatic vinyl compound unit at 90% by weight or more, and the polymer block [B] contains the linear conjugated diene compound unit at 90% by weight or more.

6. The use according to any one of claims 1 to 5, wherein the amount of the plasticizer is at 5 to 50 parts by weight with respect to 100 parts by weight of the block copolymer hydride.

7. The use according to any one of claims 1 to 6, wherein the number average molecular weight of the hydrocarbon polymer as the plasticizer is 300 to 3000.

8. An organic electronic device comprising:
an element containing an organic material; and
a layer of the resin composition as defined in any one of claims 1 to 7.

9. The organic electronic device according to claim 8, further comprising an absorbent layer lying between the element and the layer of the resin composition.

10. The organic electronic device according to claim 8 or 9, further comprising a temporary sealing layer lying between the element and the layer of the resin composition.

11. The use according to any one of claims 1 to 7 or the organic electronic device according to any one of claims 8 to 10, wherein the organic device includes an organic electroluminescent or an organic semiconductor element.

## Patentansprüche

1. Verwendung einer Harzzusammensetzung, die ein Blockcopolymerhydrid, das durch Hydrieren von 90% oder mehr aller ungesättigten Bindungen eines Blockcopolymers erhalten wird, und einen Weichmacher in einer Menge von 1 bis 50 Gewichtsteilen, bezogen auf 100 Gewichtsteile des Blockcopolymerhydrids, umfasst,
wobei das Blockcopolymer umfasst:
zwei oder mehr Polymerblöcke [A] pro einem Molekül des Copolymers, wobei der Block eine aromatische Vinylverbindungseinheit als Hauptkomponente aufweist; und
einem oder mehreren Polymerblöcken [B] pro einem Molekül des Copolymers, wobei der Block eine lineare konjugierte Dienverbindungseinheit als Hauptkomponente aufweist, und
ein Verhältnis zwischen einem Gewichtsanteil wA aller Polymerblöcke [A] in dem gesamten Blockcopolymer und einem Gewichtsanteil wB aller Polymerblöcke [B] in dem gesamten Blockcopolymer (wA:wB) 20:80 bis 60:40 beträgt, und
wobei der Weichmacher ein Kohlenwasserstoffpolymer mit einem zahlenmittleren Molekulargewicht von 200 bis 5000 ist,
zur Versiegelung einer organischen elektronischen Vorrichtung.

2. Verwendung nach Anspruch 1, wobei das gewichtsmittlere Molekulargewicht des Blockcopolymerhydrids 30.000 bis 200.000 beträgt.

3. Verwendung nach Anspruch 1 oder 2, wobei das Blockcopolymer ein Triblockcopolymer ist, bei dem die Polymerblöcke [A] an beide Enden des Polymerblocks [B] gebunden sind.

4. Verwendung nach einem der Ansprüche 1 bis 3, wobei das Blockcopolymerhydrid eine Alkoxysilylgruppe aufweist.

5. Verwendung nach einem der Ansprüche 1 bis 4, wobei der Polymerblock [A] die aromatische Vinylverbindungseinheit zu 90 Gew.-% oder mehr enthält, und der Polymerblock [B] die lineare konjugierte Dienverbindungseinheit zu 90 Gew.-% oder mehr enthält.

6. Verwendung nach einem der Ansprüche 1 bis 5, wobei die Menge des Weichmachers 5 bis 50 Gewichtsteile, bezogen auf 100 Gewichtsteile des Blockcopolymerhydrids, beträgt.

7. Verwendung nach einem der Ansprüche 1 bis 6, wobei das zahlenmittlere Molekulargewicht des Kohlenwasserstoffpolymers als Weichmacher 300 bis 3000 beträgt.

8. Organische elektronische Vorrichtung, die Folgendes umfasst:
ein Element, das ein organisches Material enthält; und
eine Schicht aus der Harzzusammensetzung nach einem der Ansprüche 1 bis 7.

9. Organische elektronische Vorrichtung nach Anspruch 8, die ferner eine absorbierende Schicht umfasst, die zwischen dem Element und der Schicht aus der Harzzusammensetzung liegt.

10. Organische elektronische Vorrichtung nach Anspruch 8 oder 9, die ferner eine temporäre Versiegelungsschicht umfasst, die zwischen dem Element und der Schicht aus der Harzzusammensetzung liegt.

11. Verwendung nach einem der Ansprüche 1 bis 7 oder organische elektronische Vorrichtung nach einem der Ansprüche 8 bis 10, wobei die organische Vorrichtung ein organisches Elektrolumineszenz- oder ein organisches Halbleiterelement enthält.

## Revendications

1. Utilisation d'une composition de résine comprenant un hydrure de copolymère séquencé obtenu par hydrogénation de 90 % ou plus de toutes les liaisons insaturées d'un copolymère séquencé et d'un plastifiant à 1 à 50 parties en poids par rapport à 100 parties en poids de l'hydrure de copolymère séquencé,
dans laquelle le copolymère séquencé comprend :
deux séquences de polymère [A] ou plus pour une molécule du copolymère, la séquence ayant un motif de composé vinylique aromatique en tant que composant principal ; et
une ou plusieurs séquences de polymère [B] pour une molécule du copolymère, la séquence ayant un motif de composé diène conjugué linéaire en tant que composant principal, et
un rapport entre une fraction pondérale wA de toutes les séquences de polymère [A] dans la totalité du copolymère séquencé et une fraction pondérale wB de toutes les séquences de polymère [B] dans la totalité du copolymère séquencé (wA:wB) est de 20:80 à 60:40, et
dans laquelle le plastifiant est un polymère hydrocarboné ayant un poids moléculaire moyen en nombre de 200 à 5 000,
pour le scellement d'un dispositif électronique organique.

2. Utilisation selon la revendication 1, dans laquelle un poids moléculaire moyen en poids de l'hydrure de copolymère séquencé est de 30 000 à 200 000.

3. Utilisation selon la revendication 1 ou 2, dans laquelle le copolymère séquencé est un copolymère triséquencé dans lequel les séquences de polymère [A] sont liées aux deux extrémités de la séquence de polymère [B].

4. Utilisation selon l'une quelconque des revendications 1 à 3, dans laquelle l'hydrure de copolymère séquencé possède un groupe alcoxysilyle.

5. Utilisation selon l'une quelconque des revendications 1 à 4, dans laquelle la séquence de polymère [A] contient le motif de composé vinyle aromatique à 90 % en poids ou plus, et la séquence de polymère [B] contient le motif de composé diène conjugué linéaire à 90 % en poids ou plus.

6. Utilisation selon l'une quelconque des revendications 1 à 5, dans laquelle la quantité du plastifiant est à 5 à 50 parties en poids par rapport à 100 parties en poids de l'hydrure de copolymère séquencé.

7. Utilisation selon l'une quelconque des revendications 1 à 6, dans laquelle le poids moléculaire moyen en nombre du polymère hydrocarboné en tant que plastifiant est de 300 à 3 000.

8. Dispositif électronique organique comprenant :
un élément contenant un matériau organique ; et
une couche de la composition de résine telle que définie dans l'une quelconque des revendications 1 à 7.

9. Dispositif électronique organique selon la revendication 8, comprenant en outre une couche absorbante intercalée entre l'élément et la couche de la composition de résine.

10. Dispositif électronique organique selon la revendication 8 ou 9, comprenant en outre une couche de scellement temporaire intercalée entre l'élément et la couche de la composition de résine.

11. Utilisation selon l'une quelconque des revendications 1 à 7 ou dispositif électronique organique selon l'une quelconque des revendications 8 à 10, dans lesquels le dispositif organique comprend un élément électroluminescent organique ou un élément semi-conducteur organique.
